# EUROPÄISCHE PATENTSCHRIFT

(11) **EP 4 042 473 B1**
(45) Veröffentlichungstag und Bekanntmachung des Hinweises auf die Patenterteilung: **15.11.2023**
(21) Anmeldenummer: 20789881.8
(22) Anmeldetag: 02.10.2020
(51) Int. Cl.: H01L 21/67, H01L 21/673

(54) **ANLAGE UND VERFAHREN ZUM VERBINDEN VON ELEKTRONISCHEN BAUGRUPPEN**
SYSTEM AND METHOD FOR CONNECTING ELECTRONIC ASSEMBLIES
SYSTÈME ET PROCÉDÉ POUR CONNEXION D'ENSEMBLES ÉLECTRONIQUES

(30) Priorität: 07.10.2019 DE 202019105520 U; 13.12.2019 DE 102019134410
(43) Veröffentlichungstag der Anmeldung: 17.08.2022
(73) Patentinhaber: PINK GmbH Thermosysteme, 97877 Wertheim (DE)
(72) Erfinder: OETZEL, Christoph, 97877 Wertheim (DE); MÜSSIG, Stefan, 97904 Dorfprozelten (DE)
(74) Vertreter: Spachmann, Holger
(86) Internationale Anmeldenummer: PCT/EP2020/077683
(87) Internationale Veröffentlichungsnummer: WO 2021/069328

(56) Entgegenhaltungen:
- EP-A1- 3 026 702
- WO-A1-2009/150239
- WO-A1-2016/187010
- US-A1- 2009 056 878
- US-A1- 2010 003 768
- US-A1- 2015 118 855
- MATZ W ET AL: "A two magnetron sputter deposition chamber for in situ observation of thin film growth by synchrotron radiation scattering", REVIEW OF SCIENTIFIC INSTRUMENTS, AIP, MELVILLE, NY, US, Bd. 72, Nr. 8, 1. August 2001 (2001-08-01) , Seiten 3344-3348, XP012039289, ISSN: 0034-6748, DOI: 10.1063/1.1384432

## Beschreibung

Die Erfindung betrifft eine Anlage zum Verbinden von elektronischen Baugruppen und/oder zum Fertigen von Werkstücken, insbesondere eine Sinter- bzw. Lötanlage. Ebenso betrifft die Erfindung eine Folienumsetzereinheit, die in der Anlage Abdeckfolien zur Abdeckung der Werkstücke bereitstellt.

Des Weiteren betrifft die Erfindung ein Verfahren zum Verbinden von elektronischen Baugruppen und/oder zum Fertigen von Werkstücken, insbesondere für eine Sinter- bzw. Lötanlage.

### STAND DER TECHNIK

Aus dem Stand der Technik sind Anlagen und Verfahren zum Verbinden von elektronischen Baugruppen, insbesondere Löt- und Sinteranlagen mit einer Prozessatmosphäre, insbesondere Vakuum oder Gasatmosphäre bekannt, die als Einzelanlagen und nicht für eine kontinuierliche Fertigung ausgelegt sind. Dabei kommt es zwischen den einzelnen Verfahrensschritten bzw. den einzelnen Positionen der Anlage zu unerwünschten Stillstandszeiten, in welchen einzelne Konfektionierungsarbeiten, wie ein Umsetzen von Werkstücken auf eine Transporteinheit oder ein Abdecken der Werkstücke mit einer Prozessabdeckung händisch, durchgeführt werden. Im Stand der Technik sind daher Anlagen zum Verbinden von elektronischen Baugruppen bekannt, die nicht voll automatisiert arbeiten. In derartigen bekannten Anlagen bzw. Verfahren werden einzelne Arbeitsschritte händisch durchgeführt und bedürfen eines manuellen Eingriffs. Hierbei können Fehler bei der Konfektionierung der Werkstücke auftreten. Solche Anlagen sind bekannt aus US2009056878 und WO2016187010.

Durch Unterbrechung der einzelnen Schritte bzw. durch Unterbrechungen zwischen den einzelnen Positionen kann die Ausbildung eines Reinraums, insbesondere einem Reinraum nach ISO 5, nicht immer sichergestellt werden.

Ein Rein- oder Reinstraum ist ein Raum, in dem die Konzentration luftgetragener Teilchen sehr gering gehalten wird. Rein- und Reinsträume werden für spezielle Fertigungsverfahren - vor allem in der Halbleiterfertigung - benötigt, wo in gewöhnlicher Umgebungsluft befindliche Partikel die Strukturierung integrierter Schaltkreise im Bereich von Bruchteilen eines Mikrometers stören würden. Weitere Anwendungen von Reinräumen oder Reinraumtechnik finden sich in der Optik- und Lasertechnologie, sowie beim hier betrachteten Sintern oder Diffusionslöten.

Internationale Standards definieren spezielle Reinheitsanforderungen für den Betrieb kontrollierter Umgebungen. Die Normen und Richtlinien regeln die Partikelkonzentration (beispielsweise die EN ISO 14644 und VDI 2083 aus 2019) oder zusätzlich die Keimbelastung der Umgebungen (beispielsweise EU-GPMP-Leitfaden aus 2019).

Für Reinsträume, wie sie in der Mikroelektronik Verwendung finden, gibt es mehrere hierarchische Bereiche mit entsprechender Reinraumklasse. So umgibt den Reinstraum (Klasse ISO 4 und besser), in dem mit Substraten gearbeitet wird, ein abgetrennter Bereich mit den benötigten Anlagen zur Beschichtung und Strukturierung.

Aufgabe der Erfindung ist es, eine Anlage bzw. ein Verfahren vorzuschlagen, die einen automatisierten, insbesondere vollautomatisierten, Ablauf ermöglicht, wodurch insbesondere die Ausbildung eines ISO 5 Reinraums sichergestellt werden kann.

Des Weiteren ist es Aufgabe der Erfindung, eine Anlage bzw. ein Verfahren vorzuschlagen, bei welchen auf eine händische Überprüfung einzelner Positionen bzw. einzelner Verfahrensschritte verzichtet werden kann.

Weiterhin wird eine Folienumsetzereinheit, insbesondere für eine Sinteranlage vorgeschlagen, bei der Abdeckfolien auf zu sinternden Werkstücke vollautomatisch aufgelegt und entfernt werden können. Die Aufgabe besteht darin, ein automatisiertes Aufnehmen sowie Auflegen der Folien zu ermöglichen, wobei ein Zusammenhaften und/oder ein Verunreinigen der Folien vermieden werden soll. Bei Lötanlagen kann bevorzugt auf eine Folienumsetzereinheit verzichtet werden.

Diese Aufgabe wird durch eine Anlage, ein Verfahren sowie durch eine Folienumsetzereinheit nach den unabhängigen Ansprüchen gelöst. Vorteilhafte Weiterentwicklungen der Erfindung sind Gegenstand der Unteransprüche.

### OFFENBARUNG DER ERFINDUNG

Gegenstand der Erfindung ist eine Anlage zum Verbinden von elektronischen Baugruppen und/oder zum Fertigen von Werkstücken, insbesondere eine Sinter-oder Lötanlage, umfassend mehrere Module zum Verbinden der elektronischen Baugruppen und/oder zum Fertigen der Werkstücke.

Es wird vorgeschlagen, dass zumindest ein Modul als Beladestation und ein Modul als Entladestation ausgebildet ist, oder ein Modul als Beladestation und als Entladestation ausgebildet ist. In beiden Fällen ist zumindest ein weiteres Modul als Fertigungsstation ausgebildet, und ein Fertigungs-Werkstückträger zur Aufnahme der elektronischen Baugruppen und/oder der Werkstücke vorgesehen, der über eine Transporteinheit von der Beladestation über die Fertigungsstation zur Entladestation automatisiert bewegbar ist, wobei die Anlage insbesondere für eine Fließfertigung ausgebildet ist.

Mit einer derartigen Anlage kann beispielsweise eine Fließfertigung erfolgen, wobei ein automatisierter und insbesondere vollautomatisierter Ablauf ermöglicht wird. Da insbesondere keine Unterbrechungen bei der Durchführung der unterschiedlichen Schritte in den unterschiedlichen Modulen erfolgt, kann beispielsweise ein Reinraum, insbesondere ein Reinraum nach ISO 5, ausgebildet werden. Die Anlage kann sich daher insbesondere für die Mikroelektronik eignen, wobei die elektronischen Baugruppen und/oder die Werkstücke Baugruppen bzw. Werkstücke der Mikroelektronik ausbilden können. Vornehmlich kann ein Einsatz bei der Herstellung von Hochleistungselektronik, und zur Bildung von Leistungshalbleiter-Kontaktstrukturen mit Bond buffern vorgesehen sein, wie es z.B. in der DE 10 2009 022 660 B3 beschrieben ist.

Die Anlage kann insbesondere eine Sinteranlage oder eine Lötanlage sein. Hierzu bietet sich ein Niederdruck-Sintern an, wie es z.B. in DE 3414065 A1; DE 10 2014 114 093 B4, DE 10 2004 019 567 B3 beschrieben ist. In diesem Zusammenhang kann Sintern zum einen das Herstellen oder Verändern von Werkstoffen unter hohem Druck sowie Temperatur, insbesondere unterhalb der Schmelztemperatur, betreffen. Werkstoffen können insbesondere keramische oder metallische Werkstoffe sein. Zum anderen kann unter Sintern das Verbinden von mehreren Elementen eines Werkstücks, beispielsweise eine Elektronikeinheit und ein Kühlkörper oder elektronische Bauteile und Leiterplatten (PCBs), verstanden werden. Dabei können temperaturbeständige Sinterverbindungen hergestellt werden. Derartige Sinterverbindungen können eine Alternative zu herkömmlichen Lötverbindungen darstellen und insbesondere in der Leistungselektronik Anwendung finden. Dazu kann bevorzugt eine Niederdruck-Verbindungstechnik (NTV), die bereits mit Erfolg bei der Herstellung großflächiger Bauelemente eingesetzt wird, zur Verbindung der Werkstücke, beispielsweise IGBT-Module eingesetzt werden. NTV nutzt ein Drucksintern einer Schicht aus Silberpulver zur Verbindungsbildung. Rasterelektronenmikroskopische Untersuchungen verdeutlichen, dass die für die NTV geeigneten Pulver bereits bei einer Temperatur von 200° C an Luft bei Umgebungsdruck spontan versintern. Bei gleichzeitiger Einwirkung eines Drucks von über 20 MPa wird die Pulverschicht zu einer festen Silberschicht kompaktiert, die in der Lage ist, hohe Scherspannungen aufzunehmen. Im Vergleich zu konventionellen Verbindungstechniken, die auf der Verfestigung einer flüssigen Phase beruhen, kann bei der NTV durch geeignete Verläufe von Druck und Temperatur während des Verbindungsprozesses die Temperatur, bei der die verbundene Anordnung frei von mechanischen Spannungen ist, in einem weiten Bereich eingestellt werden. Insbesondere ein Kupfersintern in jeglicher Form, z.B. mit einer Sinterpaste auf Kupferbasis bietet sich für eine Fließfertigungs-Sinteranlage an.

Andererseits kann die Anlage als Lötanlage, insbesondere als Vakuumlötanlage ausgebildet sein. Als Lötverfahren kann beispielsweise ein Reflow- oder Diffusionslötverfahren eingesetzt werden. Reflow-Löten oder Wiederaufschmelzlöten (engl.: reflow soldering) bezeichnet ein in der Elektrotechnik gängiges Weichlötverfahren zum Löten von elektronischen Bauteilen. Voraufgetragene Lötdepots wie Löt-Preforms werden zwischen zu verlötenden Werkstücken angeordnet und aufgeschmolzen, um eine Lötverbindung herzustellen.

Im Diffusionslöt-Prozess wird ein Lot komplett zu intermetallischer Phase legiert. Der Schmelzpunkt der resultierenden Phasen liegt deutlich über der Betriebstemperatur der aktiven Bauteile. Er ist ebenfalls stark erhöht gegenüber dem Schmelzpunkt des Lots. Außerdem besitzen die intermetallischen Phasen einen deutlich höheren Elastizitätsmodul. Der Prozess wird sowohl für das Kupfer-Zinn-System mit Einsatz in Leistungsmodulen als auch für das Gold-Zinn-System für das Löten auf Leiterplatten beschrieben. Lastwechseltests mit aktivem Ein- und Ausschalten der Chips haben ergeben, dass Bauteile mit dieser Verbindungstechnologie um eine Größenordnung höhere Zyklenzahlen erreichen.

Zur Ausbildung eines Reinraums der Sinter- oder Lötanlage sind bevorzugt die Beladestation und die Entladestation, bzw. ein Modul, das als Beladestation und Entladestation ausgebildet ist, innerhalb der Anlage angeordnet. Der Reinraum verläuft daher von der Beladestation, über die Fertigungsstation, bis zur Entladestation. In diesem abgeschlossenen System kann zumindest ein Fertigungs-Werkstückträger angeordnet sein, der automatisiert bewegt werden kann.

Zur Ausbildung einer Fließfertigung sind ein oder mehrere Fertigungs-Werkstückträger, die bevorzugt gleichartig ausgebildet sind, innerhalb der Anlage angeordnet. Ein Fertigungs-Werkstückträger kann beispielsweise eine Mehrzahl von gleichartigen elektronischen Baugruppen und/oder Werkstücken aufnehmen. Die automatisierte Bewegung des Fertigungs-Werkstückträgers bzw. der Mehrzahl von Fertigungs-Werkstückträgern erfolgt über die Transporteinheit. In dem Fall, in dem ein Modul als Beladestation und Entladestation ausgebildet ist, verläuft die Transporteinheit bevorzugt zumindest von der Beladestation bis zur Fertigungsstation und wieder zurück. Sind die Beladestation und die Entladestation als separate Module ausgebildet, wobei zwischen diesen beiden Modulen die Fertigungsstation angeordnet ist, so verläuft die Transporteinheit bevorzugt von der Beladestation, über die Fertigungsstation, bis zur Entladestation. Zur Ausbildung einer Fließfertigung wird in dieser Ausführungsform bevorzugt der Fertigungs-Werkstückträger von der Entladestation zurück zur Beladestation geführt. Dies kann beispielsweise durch ein anderes Transportverfahren bzw. eine andere Transportart erfolgen. So können die Fertigungs-Werkstückträger die komplette Anlage durchlaufen, ohne dass von außerhalb der Anlage, insbesondere händisch, eingegriffen werden muss.

Automatisiert bedeutet insbesondere, dass eine Fortbewegung ohne händischen Eingriff erfolgen kann. Dafür kann die Transporteinheit beispielsweise zumindest teilweise als eine Art Fließband und/oder als Hubeinheit ausgebildet sein. Ein weiterer Vorteil der automatisierten, insbesondere vollautomatisierten, Anlage besteht darin, dass für jedes Modul an sich, sowie für die komplette Anlage, ein Reinraum, insbesondere ein ISO 5 Reinraum, ausgebildet werden kann. So kann die Anlage an sich beispielsweise geschlossen und/oder gasdicht ausgebildet sein. Ebenso können innerhalb der Anlage einzelne Prozesskammern geschlossen und/oder gasdicht ausgebildet sein.

In einer bevorzugten Ausführungsform kann die Fertigungsstation zumindest ein weiteres Modul als Lötmodul und/oder als Sintermodul umfassen. Bevorzugt kann die Fertigungsstation mehr als ein weiteres Modul, insbesondere ein Vorheizmodul, ein Plasmamodul, ein Lötmodul und/oder ein Sintermodul und/oder ein Abkühlmodul, umfassen. Ein Vorheizmodul dient zur Vorerwärmung der zu verbindenden Werkstücke. Ein Plasmamodul kann beispielsweise zur Reinigung der Werkstücke eingesetzt werden. Das Löt- und/oder Sintermodul kann ein Verbinden der Werkstücke, insbesondere ein thermisches Fügeverfahren unter Prozessatmosphäre durchführen. Das Abkühlmodul dient zur definierten Abkühlung der Werkstücke, so dass ein hoher Fließtakt einer In-Line Fertigung, d.h. Fließfertigung erreicht werden kann. Eine oder mehrere, zusammenhängende und ggf. durch gasdichte Schleusen verbindbare Module können eine Prozessatmosphäre, insb. Unterdruck oder Vakuum als Prozessatmosphäre zum Verbinden der Werkstücke bereitstellen.

Bevorzugt sind die weiteren Module zwischen der Beladestation und der Entladestation angeordnet. Sind die Beladestation und die Entladestation in einem gemeinsamen Modul integriert, sind die weiteren Module bevorzugt auf zumindest einer Seite bezüglich der Beladestation bzw. Entladestation angeordnet. Die Anlage kann beispielsweise als langgestreckte Durchlaufanlage ausgebildet sein. Bevorzugt kann der Fertigungs-Werkstückträger alle Module der Anlage automatisiert durchlaufen. Es ist denkbar, dass der Fertigungs-Werkstückträger die Anlage in beiden Richtungen, d. h. hin und zurück, durchlaufen kann, sodass ein Kreislauf entsteht. Dadurch kann besonders vorteilhaft eine Fließbandfertigung ausgebildet werden, die automatisiert erfolgt. Die Hin- und Zurückbewegung kann auf unterschiedlichen Ebenen innerhalb der Anlage erfolgen.

In einer bevorzugten Ausführungsform kann ein Modul als Beladestation und ein Modul als Entladestation ausgebildet sein, wobei die Beladestation der Fertigungsstation vorgeschaltet ist und die Entladestation der Fertigungsstation nachgeschaltet ist, und eine Transporteinheit die elektronischen Baugruppen und/oder Werkstücke von der Entladestation, insbesondere unter Umgehung der Fertigungsstation, zurück zur Beladestation transportiert. Als Umgebung der Fertigungsstation ist insbesondere keine räumliche Umgehung, sondern eine funktionale Umgebung zu verstehen. Die Fertigungsstation kann beispielsweise eine funktionale Arbeitsstation sein, die insbesondere zumindest eine geschlossene und/oder gasdichte Prozesskammer umfasst. Bei einer Umgehung der Fertigungsstation kann diese geschlossene Prozesskammer bei der Rückführung des Fertigungs-Werkstückträgers umgangen werden. Dabei kann beispielsweise die Transporteinheit für die Rückführung außerhalb der Prozesskammer, jedoch innerhalb eines die Fertigungsstation umgebenden Außengehäuses, angeordnet sein. Eine Rückführung des Fertigungs-Werkstückträgers kann beispielsweise unterhalb oder neben der zumindest einen Arbeitsstation bzw. Prozesskammer der Fertigungsstation erfolgen. Insbesondere erfolgt die Rückführung innerhalb der Anlage, wobei bevorzugt der Fertigungs-Werkstückträger die Anlage während der kompletten Fertigung, insbesondere Fließfertigung, nicht verlässt. Die Transporteinheit kann gemäß eines Fließbandprinzips oder eines Kettenführungsprinzips aufgebaut sein. Zur Vertikalförderung von einer unterhalb der Arbeitsstation angeordneten Rückführungs-Transporteinheit kann eine Hubeinrichtung vorgesehen sein, auf dem die Werkstückträger nach einem Liftprinzip verfahren werden können.

In der Regel kann ein Transport-Werkstückträger als Fertigungs-Werkstückträger verwendet werden, insofern ist kein Umsetzen der Bauteile zwischen den verschiedenen Werkstückträgertypen erforderlich und auf einen Rücktransport des Fertigungs-Werkstückträgers kann verzichtet werden.

In einer bevorzugten Ausführungsform kann in der Beladestation und/oder Entladestation zumindest ein Automatisierungsroboter vorgesehen sein, durch den die elektronischen Baugruppen und/oder die Werkstücke von einem Transport-Werkstückträger auf den Fertigungs-Werkstückträger in der Beladestation automatisiert überführbar und ggf. auflegbar sind. Über den Transport-Werkstückträger können die elektronischen Baugruppen und/oder die Werkstücke der Anlage zugeführt werden. Bevorzugt innerhalb der Beladestation erfolgt ein Umsetzen von dem Transport-Werkstückträger auf den Fertigungs-Werkstückträger. Dies erfolgt über einen Automatisierungsroboter, der bevorzugt innerhalb der Beladestation angeordnet ist. In einer Ausführungsform kann beispielsweise ein Automatisierungsroboter vorgesehen sein, der zum Beladen des Fertigungs-Werkstückträgers an der Beladestation sowie zum Entladen des Fertigungs-Werkstückträgers an der Entladestation ausgebildet ist. Dieser ermöglicht ein Umsetzen der Baugruppen von einem - typischerweise herstellerspezifischen - Transport-Werkstückträger auf einen anlagespezifischen Fertigungs-Werkstückträger. Dabei kann der Fertigungs-Werkstückträger beispielsweise eine Mehrzahl von Baugruppen aufnehmen, wobei der Transport-Werkstückträger nur eine, oder wenige Baugruppen transportiert. Insofern können auf einem Fertigungs-Werkstückträger Baugruppen einer Mehrzahl von Transport-Werkstückträger aufgenommen werden. Vorteilhaft kann zum Umsetzen ein Sauggreifer verwendet werden, der mittels Unterdruck und unter Vermeidung von mechanischen Greifkräften die Werkstücke anheben kann. Des Weiteren können mehr als ein Automatisierungsroboter innerhalb der Anlage vorgesehen sein. In einer bevorzugten Ausführungsform ist ein Automatisierungsroboter in der Beladestation, ein weiterer Automatisierungsroboter in der Entladestation angeordnet. Dadurch kann ein kontinuierliches Beladen bzw. Entladen der Fertigungs-Werkstückträger innerhalb der Anlage erfolgen, wodurch eine Fließfertigung besonders vorteilhaft erreicht werden kann. Die Spezifikation der Transport-Werkstückträger ist somit unabhängig von der Spezifikation des vom Fügeprozess, z.B. Sinter- oder Lötprozess-geeigneten Fertigungs-Werkstückträger.

Eine korrekte Konfektionierung, insbesondere Lage und Anordnung der Baugruppen auf dem Fertigungs-Werkstückträger in der Beladestation kann optisch mittels einer Kamera überprüft und archiviert werden. Auch kann zur Ausrichtung eines Greifarms eines Automatisierungsroboters / Handlingroboters eine Kamera zur optischen Ausrichtung in der Be- und/oder Entladestation vorgesehen sein. Der Automatisierungsroboter kann als üblicher Industrieroboter mit einem um mehrere Achsen bewegbaren Arm ausgeführt sein. Es kann auch als ein- oder mehrachsiges Transportsystem zum Transport von Werkstückträger, Folien, Abdeckmasken etc. ausgeführt sein.

In bzw. vor der Beladestation kann ein Stapelmagazin für Fertigungs-Warenträger vorgesehen sein, die insbesondere zu Beginn der Produktion ein Bestücken der Transporteinheit mit einer sequentiellen Kette von Fertigungs-Warenträger ermöglicht. Somit kann sofort ein kontinuierlicher Prozess angefahren werden, und es muss nicht auf einen Rücklauf der ersten Fertigungs-Warenträgers gewartet werden. Somit können bereits beim Hochlaufen der Fertigung hohe Stückzahlgeschwindigkeiten erreicht werden.

Insbesondere am Ende eines Batch-Arbeitsablaufs, bei der eine Anzahl von Werkstückträgern gefügt werden soll, kann im Falle eines letzten Fertigungs-Werkstückträgers, der nicht mit Werkstücken vollständig befüllt werden kann, Dummy-Werkstücke auf die verbleibenden leeren Plätze des Fertigungs-Werkstückträgers gesetzt werden, die nach dem Fügeprozess, insbesondere einem Sinter- oder Diffusionslötprozess, wieder vom Fertigungs-Werkstückträger auf eine Dummy Position zurückgelegt werden kann.

In einer bevorzugten Ausführungsform kann eine weitere Transporteinheit zur Aufnahme des Transport-Werkstückträgers vorgesehen sein, die unabhängig von den Modulen von der Beladestation zu der Entladestation, insbesondere unter Umgehung der Fertigungsstation, verfahrbar ist. Diese weitere Transporteinheit kann beispielsweise in der Beladestation der Anlage zugeführt werden, sowie in der Entladestation aus der Anlage herausgeführt werden. Auf dem Transport-Werkstückträger sind insbesondere die Rohlinge oder unverbundenen Bauteile angeordnet, die von externen Herstellern stammen können. Die Umgehung der Fertigungsstation ist wie bereits zuvor erläutert, zu verstehen. Insbesondere kann die weitere Transporteinheit eigenständig, sowie insbesondere unabhängig von der Transporteinheit der Fertigungs-Werkstückträger der Anlage verfahrbar sein. Bevorzugt kann die Transporteinheit der Transport-Werkstückträger parallel zu den Modulen der Anlage verfahren.

In einer bevorzugten Ausführungsform kann die Beladestation eingerichtet sein, eine Prozessabdeckung auf die elektronischen Baugruppen und/oder die Werkstücke aufzubringen, und/oder die Entladestation eingerichtet sein, die Prozessabdeckung von den elektronischen Baugruppen und/oder den Werkstücken zu entfernen, insbesondere mittels eines Automatisierungsroboters aufzubringen und/oder zu entfernen. Bei der Prozessabdeckung kann es sich um eine Maske bzw. Abdeckmaske, insbesondere für einen Sinterprozess, handeln, die auf die elektronischen Baugruppen und/oder Werkstücke, die auf dem Fertigungs-Werkstückträger angeordnet sind, automatisiert aufgelegt werden kann. Die Aufbringung kann über eine automatisierte Vorrichtung bzw. einen Automatisierungsroboter erfolgen. Dabei kann die Prozessabdeckung zwischen einer Parkposition, insbesondere zum Zwischenlagern der Prozessabdeckung, und zwischen der Position auf dem Fertigungs-Werkstückträger hin und her bewegt bzw. verschoben werden. Die Prozessabdeckung kann auf einer Art Lagervorrichtung gelagert werden und über eine Schiene an die entsprechende Position verschoben werden. Dies kann computergesteuert geregelt werden. Sind mehrere Fertigungs-Werkstückträger innerhalb der Anlage vorgesehen, insbesondere für eine kontinuierlichen Fertigung, so sind bevorzugt mehrere Prozessabdeckungen innerhalb der Anlage angeordnet. Beispielsweise kann an der Parkposition kontinuierlich eine Prozessabdeckung aufgelegt werden, wenn die zuvor dort angeordnete Prozessabdeckung entnommen, bzw. auf den Fertigungs-Werkstückträger aufgelegt, wurde. Des Weiteren kann jeweils eine Prozessabdeckung für einen Fertigungs-Werkstückträger vorgesehen sein, wobei bei Rückführen des Fertigungs-Werkstückträgers die Prozessabdeckung mit dem Fertigungs-Werkstückträger rückgeführt wird. Die Prozessabdeckung kann vor dem Rückführen von der Entladestation zur Beladestation für den Rücktransport wieder auf den Fertigungs-Werkstückträger aufgelegt werden.

In einer bevorzugten Ausführungsform kann die Beladestation und/oder die Entladestation zumindest zwei Arbeitspositionen, insbesondere drei oder vier Arbeitspositionen, umfassen, wobei der Fertigungs-Werkstückträger von einer Arbeitsposition zu einer benachbarten Arbeitsposition automatisiert, insbesondere über eine Verfahreinheit, verfahrbar ist. Jede der Arbeitspositionen kann einen von der anderen Arbeitsposition unterschiedlichen Arbeitsschritt ausüben. In einer ersten Arbeitsposition kann beispielsweise die Prozessabdeckung, insbesondere eine Abdeckmaske, auf den Fertigungs-Werkstückträger mit den elektronischen Baugruppen und/oder den Werkstücken, aufgelegt werden. Nach Durchlaufen der letzten Arbeitsposition sind die elektronischen Baugruppen und/oder die Werkstücke auf dem Fertigungs-Werkstückträger bevorzugt derart vorbereitet, dass diese die Fertigungsstation, insbesondere ein Vorheizmodul, Löt- oder Sintermodul und Abkühlmodul, durchlaufen kann. Die Verfahreinheit kann als eine Art Transporteinheit ausgebildet sein, beispielsweise als Fließband oder Transportband. Die Verfahreinheit kann zusammen mit der Transporteinheit zum Rücktransport der Fertigungs-Werkstückträger eine Art Kreislauf ausbilden, um eine Fließfertigung auszubilden. Sind mehrere Fertigungs-Werkstückträger in der Anlage angeordnet, so sind diese bevorzugt in einem kontinuierlichen Abstand zueinander auf der Verfahreinheit angeordnet. Die Arbeitsstationen können sequentiell und linear hintereinander oder auch in Form eines Rundtakttisches kreisförmig benachbart zueinander angeordnet sein.

In der Erfindung umfasst die Beladestation drei Arbeitspositionen die über eine Verfahreinheit miteinander verbunden sind. Dazu können auf einer ersten Arbeitsposition die elektronischen Baugruppen und/oder die Werkstücke durch einen Automatisierungsroboter automatisiert aufgelegt werden. Zumindest eine Maske kann als erste Prozessabdeckung auf die elektronischen Baugruppen und/oder auf die Werkstücke über einen Automatisierungsroboter automatisiert aufgelegt werden. Alternativ oder zusätzlich kann in einer zweiten Arbeitsposition zumindest eine Folie als zweite Prozessabdeckung auf die Maske über eine Automatisierungsroboter automatisiert aufgelegt werden, und in einer dritten Arbeitsposition kann ein Verschließen des Fertigungs-Werkstückträgers mit der Folie, insbesondere über einen Halterahmen, insbes. Haltering, automatisiert erfolgen. Es ist denkbar, dass ein einzelner Automatisierungsroboter zur Ausführung aller Vorgänge in allen Arbeitspositionen vorgesehen ist. Bevorzugt sind an jeder Arbeitsposition separate Automatisierungsroboter bzw. andersartige computergesteuerte Aktuatorvorrichtungen vorgesehen, um die jeweiligen Arbeitsschritte in den Arbeitspositionen durchzuführen.

Bei der Folie kann es sich beispielsweise um eine temperaturfeste Ausgleichsfolie z.B. für Temperaturbereiche um 250°C, z.B. eine PTFE-Folie, eine FKM-Folie, eine Silikonfolie, eine Polyurethanelastomere-Folie, Eladur-Folien eine PFA-Folie, PI-Folie oder ähnliches wie eine Graphit-Folie, eine Aluminium-Folie oder ähnliches handeln. Bevorzugt kann die Folie als Schutz eines SMD (Surface Mounted Device)-Schablone dienen. SMD-Bauteile haben eine extrem kleine Bauform. Derartige elektronische Bauteile haben keine Drahtanschlüsse, sondern können mittels lötfähiger Anschlussflächen direkt auf eine Platine gelötet werden. Diese Technik kann auch als Oberflächenmontage bezeichnet werden. Die Folie kann ein unerwünschtes Anheften eines Gelkissens auf einer Bauteiloberfläche im Rahmen eines Sinterprozesses verhindern.

In einer bevorzugten Ausführungsform können die Beladestation und die Entladestation gespiegelt zueinander ausgebildet sein. Dadurch können besonders vorteilhaft die elektronischen Baugruppen und/oder die Werkstücke in der Beladestation kontinuierlich für den anschließenden Sintervorgang oder Lötvorgang vorbereitet werden. In der Entladestation hingegen können die zum Sintern bzw. Löten notwendigen Hilfsvorrichtungen, wie eine Prozessabdeckung oder Folie, kontinuierlich wieder entfernt werden. Da insbesondere die Arbeitsschritte der Beladestation komplementär in der Entladestation durchgeführt werden, können die beiden Module bevorzugt baugleich, jedoch gespiegelt bzw. komplementär zueinander ausgebildet sein.

In einer bevorzugten Ausführungsform kann die Transporteinheit zum Transport des Fertigungs-Werkstückträgers eine Hubeinheit und eine Unterflurfördereinheit umfassen, wobei der Verfahrweg der Unterflurfördereinheit innerhalb der Anlage, und insbesondere unter Umgehung der Fertigungsstation, insbes. einer gasdichten Prozesskammer, angeordnet ist, und insbesondere unterhalb einer Ebene verläuft, in der ein Beladen und/oder Entladen des Fertigungs-Werkstückträgers und Transport des Fertigungs-Werkstückträgers durch die Fertigungsstation erfolgt. Eine Umgehung der Fertigungsstation ist wie bereits oben erläutert zu verstehen. Durch die Unterflurfördereinheit kann der Fertigungs-Werkstückträger parallel zu den Arbeitspositionen der Beladestation bzw. Entladestation bewegt werden. Dadurch kann Bauraum eingespart werden, da die Rückführung innerhalb der Anlage erfolgen kann. So kann der Fertigungs-Werkstückträger besonders vorteilhaft von der Beladestation zur Entladestation verfahren werden. In der Entladestation kann die weitere Transporteinheit die elektronischen Baugruppen und/oder die Werkstücke aus dem Fertigungs-Werkstückträger aufnehmen, bevor der Fertigungs-Werkstückträger zu der Beladestation zurückgeführt wird.

In einer bevorzugten Ausführungsform kann eine optische Inspektionseinheit vorgesehen sein, die zumindest eine Inspektionskamera umfasst. Die zumindest eine Inspektionskamera kann in der Beladestation und/oder in der Entladestation sein, und kann zumindest eine lagerichtige Ausrichtung der Baugruppen und/oder der Werkstücke in dem Fertigungs-Werkstückträger erfassen und protokollieren. Die Inspektionskamera kann die Drehlage und einen X-Y-Versatz der Werkstücke auf dem Fertigungs-Werkstückträger überprüfen. Bevorzugt kann die Inspektionskamera oder eine zweite Inspektionskamera weiterhin die Drehlage und einen X-Y-Versatz der Werkstücke auf einem Transport-Werkstückträger erfassen. Die Inspektionskamera kann mit einer Beleuchtungseinheit versehen sein. Vorteilhaft kann die Inspektionskamera an einen Greifarm eines Automatisierungsroboters angeordnet sein, der für ein Umsetzen der Werkstücke vom Transport-Werkstückträger auf den Fertigungs-Werkstückträger sorgt, angeordnet sein. Derartige optische Inspektionskameras können sowohl in der Beladestation als auch in der Entladestation umfasst sein. Die Inspektionseinheit kann eine Aufzeichnung der Lage und des Erscheinungsbildes vor- und nach Verbinden der Werkstücke durchführen. Daneben kann die Inspektionseinheit den Automatisierungsroboter steuern. So kann nach dem Greifen eines Werkstücks durch den Automatisierungsroboter mittels einer ersten Inspektionskamera eine Lagekorrektur des Automatisierungsroboters ermittelt werden. Mit einer zweiten Inspektionskamera kann die exakte Position des Fertigungs-Werkstückträgers ermittelt werden, so dass die Werkstücke ohne Lageversatz und in exakter Ausrichtung im Fertigungs-Werkstückträger ablegbar sind. Somit können Fehlpositionierungen eines Werkstücks im Transport-Warenträgers korrigiert und eine exakte Positionierung im Fertigungs-Werkstückträger sichergestellt werden.. Hierzu können auf dem Fertigungs-Werkstückträger eine oder mehrere optische Referenzmarken zur vereinfachten Erfassung durch die Inspektionseinrichtung vorgesehen sein. Die Referenzmarken ermöglichen eine sichere und exakte Erkennung der Lageposition, so dass eine Inspektionskamera mit einer geringen optischen Auflösung oder bei schwierigen Lichtverhältnissen bzw. einer einfachen Hilfsbeleuchtung eingesetzt werden kann. Auch kann eine leichtgewichtige Inspektionskamera beispielsweise an einem Greifarm eingesetzt werden, so dass eine hohe Verfahrgeschwindigkeit und ein geringes Gewicht des Automatisierungsroboters erreicht werden kann.

Die Erfindung umfasst Folienumsetzereinheit mit zumindest einem, insbesondere zwei oder mehreren Folienumsetzern, die zum automatisierten Aufbringen von Folien als eine Prozessabdeckung in der Beladestation ausgebildet sind. Die Folienumsetzereinheit ist dazu ausgebildet, jeweils eine Folie auf den Fertigungs-Werkstückträger mit den elektronischen Baugruppen und/oder den Werkstücken und der Maske aufzulegen. Ein Folienumsetzer kann beispielsweise mit einem Greifer ausgebildet sein, wobei ein Aufnehmen der Folie pneumatische und/oder über Vakuum erfolgen kann. Insoweit kann ein Folienumsetzer als Handlingseinheit angesehen werden, die in der Lage ist, eine Folie, die als vorgeschnittenes Folienstück vorliegen kann, aufzunehmen, und räumlich an einem anderen Ort wieder abzulegen. Beispielsweise kann über einen Vakuumsauger, der an dem Folienumsetzer angeordnet ist, eine Folie aufgenommen werden. Folglich kann das Auflegen der Folie automatisiert bzw. voll automatisiert erfolgen. Ein händischer Eingriff ist nicht notwendig. Dadurch kann ein Reinraum, insbesondere ein ISO 5 Reinraum, ausgebildet werden.

In der Erfindung umfasst die Folienumsetzereinheit zumindest ein, insbesondere zwei, Folienstapel die als Folienmagazin ausgebildet sind und an einer Oberseite eine Entnahmefläche für eine obere Folie aufweisen. Der Folienstapel kann folglich aus einem Stapel einzelner Folien, bereits vorgeschnittenen sein können, ausgebildet sein, die kontinuierlich, insbesondere in einer Arbeitsposition in der Beladestation, auf die Fertigungs-Werkstückträger, welche die Arbeitsposition durchlaufen, aufgelegt werden können. Dafür kann jeweils an der Entnahmefläche, d. h. an der Seite, an der die oberste oder die unterste Folie des Stapels angeordnet ist, die oberste bzw. unterste Folie entnommen werden. Der zumindest eine Folienstapel, insbesondere zwei Folienstapel können neben der bzw. in der Beladestation angeordnet sein. Sind zwei Folienstapel vorhanden, kann besonders vorteilhaft eine unterbrechungsfreie Fließfertigung bereitgestellt werden. So kann ein erster Folienstapel nachgefüllt werden, während von dem zweiten Folienstapel weiterhin Folien entnommen werden können. Die Folienumsetzereinheit mit den Folienstapel sowie den Folienumsetzern kann bevorzugt innerhalb der Anlage angeordnet sein.

Durch den Folienstapel mit vorgeschnittenen Folien kann der Folienzuschnitt optimiert, Abfall reduziert und damit Kosten gespart werden. Bevorzugt können die Folien an die Form des Fertigungs-Werkstückträgers und des Halterahmens angepasst, insbesondere rund, rechteckig, quadratisch oder sechseckig ausgeführt sein. Der Folienwechsel sowie der Wechsel zwischen den beiden Folienstapel erfolgt automatisch, so dass hohe Taktzeiten und praktisch keine Produktionsverzögerung oder -stillstand auftritt. Es kann eine Temperaturhomogenisierung des Folienstapels und der Umgebungstemperatur erreicht werden, was bei Rollenentnahme der Folie nicht gewährleistet ist. Auch können auf dem Folienstapel Folienzuschnitte unterschiedlicher Dicke und Folien- bzw. Materialtypen für eine sequentielle Entnahme vorgesehen sein und leicht angepasst werden. Auch können bei Produktionsbeendigung Foliendummies z.B. als Kunststoff- oder Metallbleiche im Folienstapel vorgesehen sein, so dass kein unnötiger Verschnitt oder ungenutzter Folienabfall anfällt. Die Dicke der Folien kann 1mm oder weniger, insbesondere 0,25 mm oder weniger, bevorzugt 0,1 mm oder weniger, im Speziellen 0,05mm oder weniger betragen, auch kann die Anzahl der Folien im Folienstapel exakt an die Menge der zu verarbeitenden Baugruppen / Bauteilen ausgerichtet werden. Zur Be- und Entladung des Folienstapels könne ESD-Techniken zum elektrostatischen Entladen eingesetzt werden, um ein elektrostatisches Anhaften der Folien aneinander zu verhindern.

Grundsätzlich ist denkbar, eine unterste oder eine oberste Folie von einem Folienstapel zu entnehmen. In einer bevorzugten Ausführungsform kann der Folienstapel über eine Folien-Hebeeinheit verfügen, die ein schrittweises Anheben des Folienstapels in Richtung der Oberseite ermöglicht. Eine oberste Folie des Folienstapels kann auf diese Weise im Wesentlichen auf konstanter Höhe angeordnet werden. Dadurch kann sichergestellt werden, dass der Folienumsetzer jeweils die oberste Folie des Folienstapels erreichen kann, wenn dieser sich auf ein und demselben Verfahrweg, insbesondere kontinuierlich auf der gleichen Höhe, bewegt.

Mit einer Folienumsetzereinheit können insbesondere Folien, insbesondere eine temperaturfeste Ausgleichsfolie z.B. für Temperaturbereiche um 250°C, z.B. eine PTFE-Folie, eine FKM-Folie, eine Silikonfolie, eine PFA-Folie, PI-Folie, Aluminium-Folie, Graphit-Folie oder ähnliche, aufgenommen werden. Der Einsatz solcher Folien wurde bereits erläutert, sie können in einem Sinterverfahren als Prozessabdeckung zwischen einem Sinterkissen oder einem Hartstempel und einer Bauteiloberfläche und/oder einer Abdeckmaske auf den Bauteilen dienen.

In einer bevorzugten Ausführungsform kann eine Reinigungseinheit für eine Reinigung einer obersten und/oder untersten Folie vor dem Umsetzen auf die elektronischen Baugruppen und/oder auf die Werkstücke umfasst sein. Dadurch kann jede Folie, beispielsweise vor einem Aufsetzen auf einen Fertigungs-Werkstückträger mit elektronischen Baugruppen und/oder Werkstücken, mithilfe der Reinigungseinheit gereinigt werden. Die Reinigungseinheit kann beispielsweise zwischen einem Folienstapel und der Position des Fertigungs-Werkstückträgers angeordnet sein.

Beim Abnehmen einer Folie vom Folienstapel können diese - vornehmlich durch statische Aufladung hervorgerufen - aneinander haften. Um dies zu vermeiden, und um auch verschiedene Folienwerkstoffe verwenden zu können, können diese vorteilhaft statisch entladen werden. Diese kann beispielsweise über ein lonisationssystem z.B. von Keyence Deutschland GmbH, Neu-Isenburg erfolgen. Mit Hilfe einer automatischen lonenregelung eines lonisierers werden elektrostatische Ladungen unabhängig von der Polarität, schnell und zuverlässig neutralisiert. Dabei können Entladungsstäbe zum Aufbringen der Ionen mit oder ohne Druckluft betrieben werden.

In einer bevorzugten Ausführungsform kann der Folienstapel als Folienmagazin mit einer Folien-Hebeeinheit ausgebildet sein, sodass eine jeweils oberste Folie des Folienstapels um einen Hub nach oben in Richtung der Oberseite verfahrbar ist, und der Folienumsetzer ein Höhenausgleichsystem aufweist. Beispielsweise kann jeweils nach einer gewissen Anzahl an entnommenen Folien der Folienstapel um einen Hub von 5 mm bis 15 mm, insbesondere 10 mm, nach oben verfahren werden. Die Folien-Hebeeinheit kann beispielsweise nach 5 bis 15, insbesondere 10, entnommenen Folien den Folienstapel um 10 mm nach oben verfahren. Durch das Höhenausgleichsystem kann der Folienumsetzer Abweichungen von der Höhe, auf welcher sich die zu entnehmende oberste Folie befindet, ausgleichen. Dadurch kann der Folienumsetzer quasi eine Toleranz beim Aufnehmen der Folien bereitstellen. Insbesondere kann so die Toleranz der Höhe, auf der sich eine oberste Folie des Folienstapels befindet, ausgeglichen werden.

In einer bevorzugten Ausführungsform kann ein Folienstapel eine Vielzahl an Folien enthalten. Insbesondere kann ein Folienstapel Folien für eine Produktion über einen Zeitraum von beispielsweise 24 Stunden enthalten. Andere Zeiträume sind ebenso denkbar.

In einer bevorzugten Ausführungsform kann die Reinigungseinheit eine Linearreinigungseinheit umfassen oder als berührungslos arbeitendes Oberflächenreinigungssystem ausgebildet sein. Durch die Linearreinigungseinheit kann jeweils eine Folie durch das Reinigungssystem geschoben werden. Dabei kann die Folie beispielsweise zunächst mit einem ersten Folienumsetzer auf die Linearreinigungseinheit aufgelegt werden, dort verschoben und gereinigt werden, und anschließend mit einem zweiten Folienumsetzer wieder von der Reinigungseinheit entnommen werden.

In einer bevorzugten Ausführungsform kann die Reinigungseinheit als berührungsloses arbeitendes Oberflächenreinigungssystem ausgebildet sein. So können Verschmutzungen von dreidimensionalen oder strukturierten Oberflächen vorteilhaft beseitigt werden. Beispielsweise können durch eine pulsierende und hochturbulente Luftströmung Verunreinigungen entfernt werden. Insbesondere können unter Verwendung von Druckluft und/oder Vakuum und/oder ionisierter Luft, insbesondere in dieser Reihenfolge, positive sowie negative Ladungen in die Folie eingebracht werden, um elektrostatische Anhaftungen von Schmutzpartikel auf der Folienoberfläche zu unterbinden.

In einer bevorzugten Ausführungsform kann in der Reinigungseinheit durch ein Einbringen von positiver sowie negativer Ladungen in die Folie, die Folie elektrostatisch entladen werden. Bevorzugt können anschließend über Luft mit hohem Druck, die auf die Folie geblasen wird, die Verunreinigungen bzw. Partikel entfernt werden. Insbesondere werden anschließend die Partikel abgesaugt, beispielsweise durch eine Absaugeinheit. Als Ergebnis liegt die Folie in entladenem Zustand vor, sodass keine Partikel aufgrund elektrostatischer Anziehung anhaften können. Dieses Verfahren eignet sich insbesondere für temperaturfeste Ausgleichsfolien z.B. für Temperaturbereiche um 250°C, z.B. eine PTFE-Folie, eine FKM-Folie, eine Silikonfolie, eine PFA-Folie, PI-Folie, Aluminium-Folie, Graphit-Folie oder ähnliche Folienarten.

Eine berührungslose Reinigung kann beispielsweise durch pulsierende Druckluft einer Rotationsdüse oder durch eine Flachstrahldüse erfolgen. Diese eignet sich beispielsweise für strukturierte Bauteile. Durch Ionisation können elektrostatischer Ladungen aufgehoben werden, so dass eine elektrostatische Anziehung aufgehoben werden kann. Besonders vorteilhaft hat sich eine Ionisation mit Druckluftunterstützung durch Flachstrahldüsen herausgestellt. Insbesondere kann ein Absaugkanal integriert sein. Derartige Reinigungseinheiten können eine kompakte Bauform für schmale Arbeitsbreiten aufweisen. Diese können auch zur Nachrüstung in bestehende Produktionsanlagen eingesetzt werden.

In einer bevorzugten Ausführungsform kann die Reinigungseinheit als STATIK-AIR Produktreihe der Dr. Escherich GmbH, München ausgebildet sein. Diese bietet eine berührungslos arbeitende Oberflächenreinigung bei Aufhebung elektrostatischer Ladungen und Entfernung störender Staub- und Materialpartikel. Für eine Reinraumanwendung ist ein integrierter Absaugkanal vorgesehen.

Bevorzugt haften einzelne Folien, insbesondere temperaturfeste Ausgleichsfolien z.B. für Temperaturbereiche um 250°C, z.B. PTFE-Folien, FKM-Folien, Silikonfolien, PFA-Folien, PI-Folien, Aluminium-Folien, Graphit-Folien oder vergleichbar, durch positive sowie negative Aufladungen nicht aneinander. Die Folien können so quasi entionisiert vorliegen. Dadurch kann sichergestellt werden, dass durch den Folienumsetzer nur eine oberste Folie von einem Folienstapel entnommen wird.

In einer bevorzugten Ausführungsform kann durch eine Höhenmessung und/oder Dickenmessung ermittelt werden, ob zwei Folien aufgenommen wurden. Die Höhenmessung bzw. Dickenmessung kann beispielsweise als Transparenzmessung ausgebildet sein, wobei durch Ermittlung der optischen Transparenz der aufgenommenen Folie bzw. Folien ermittelt werden kann, ob es sich lediglich um eine Folie handelt. Alternativ kann - um eine Prüfung der zuverlässigen Vereinzelung der Folien zu erreichen - insbesondere nach der Reinigungsstation und vor dem Auflegen der Folie auf den Fertigungs-Werkstückträger bzw. auf die Baugruppe oder die Baugruppen, die Dicke der Folie mechanisch gemessen werden. Dies kann beispielsweise mittels Abtastspitzen z.B. auf der Oberfläche des Folienstapels erfolgen. Dabei kann das Dickenmesssystem für alle Formen, Werkstoffe und Dicken der Abdeckfolien eingesetzt werden. Insbesondere können sowohl opake als auch transparente Folien damit geprüft werden. Somit kann auch bei dicken Ausgleichfolien sprich Folien zum Höhenausgleich wie z.B. Silikonmatten oder spiegelnden Folien eine Vereinzelungsprüfung durchgeführt werden.

In einer bevorzugten Ausführungsform kann ein erster Folienumsetzer zum Entnehmen einer obersten und/oder untersten Folie von dem Folienstapel und Einlegen in die Reinigungseinrichtung ausgebildet sein, ein zweiter Folienumsetzer zum Entnehmen der Folie aus der Reinigungseinheit und Auflegen auf den Fertigungs-Werkstückträger mit den elektronischen Baugruppen und/oder den Werkstücken ausgebildet sein.

Des Weiteren betrifft die Erfindung ein Verfahren zum Verbinden von elektronischen Baugruppen und/oder zum Fertigen von Werkstücken, insbesondere zur Fließfertigung.

Es wird vorgeschlagen, dass eine Vorkonfektionierung von elektronischen Baugruppen und/oder Werkstücken auf einem Fertigungs-Werkstückträger in der Beladestation erfolgt. Dies erfolgt als Vorbereitung zu einer Bearbeitung, insbesondere Fügung, in einer Fertigungsstation, insbesondere umfassend ein Vorheizmodul, ein Löt- oder Sintermodul als Fügemodul und/oder ein Abkühlmodul.

Es wird vorgeschlagen, dass ein automatisiertes Verfahren des Fertigungs-Werkstückträgers von der Beladestation zu zumindest der Fertigungsstation erfolgt. In einem weiteren Schritt erfolgt anschließend ein automatisiertes Rückführen des Fertigungs-Werkstückträgers zu der Beladestation, insbesondere unter Umgehung der Fertigungsstation. Als Umgebung der Fertigungsstation ist insbesondere keine räumliche Umgehung, sondern eine funktionale Umgebung zu verstehen. Dies ist, wie bereits bezüglich der Anlage erläutert zu verstehen. Es ist weiterhin denkbar, dass der Fertigungs-Werkstückträger nicht zu der Beladestation, sondern zu einer Entladestation, nach Durchlaufen der Fertigungsstation, geführt wird.

Alternativ kann der Transport-Werkstückträger als Fertigungs-Werkstückträger verwendet werden, insofern ist kein Umsetzen der Bauteile zwischen den verschiedenen Werkstückträgertypen erforderlich und auf einen Rücktransport des Fertigungs-Werkstückträgers kann verzichtet werden.

Für das Verfahren geltende weiterhin dieselben Merkmale sowie Vorteile wie anhand der erfindungsgemäßen Anlage erläutert. Mit dem erfindungsgemäßen Verfahren wird ein automatisierter, insbesondere vollautomatisierter, Ablauf beim Verbinden von elektronischen Baugruppen und/oder beim Fertigen von Werkstücken ermöglicht. Des Weiteren kann auf eine händische Überprüfung einzelner Verfahrensschritte verzichtet werden. Dadurch kann insbesondere ein Reinraum, bevorzugt ein ISO 5 Reinraum, ausgebildet werden.

Das Verfahren kann beispielsweise zur Ausbildung von Lötverbindungen oder Sinterverbindungen von elektronischen Baugruppen und/oder Werkstücken eingesetzt werden. Derartige Sinterverbindungen können eine Alternative zu herkömmlichen Lötverbindungen darstellen und insbesondere in der Leistungselektronik Anwendung finden. Bezüglich der Sinterverbindungen sei auf die Ausführungen bezüglich der Anlage verwiesen.

Zur Ausbildung einer Fließfertigung kann das vorgestellte Verfahren kontinuierlich und wiederholt durchgeführt werden. So kann eine Vielzahl von elektronischen Baugruppen und/oder Werkstücken dem Verfahren unterzogen werden. Insbesondere können dafür mehrere Fertigungs-Werkstückträger in der Beladestation, in bevorzugt gleichen Zeitabständen, vorkonfektioniert bzw. beladen werden.

In der Regel kann ein Transport-Werkstückträger als Fertigungs-Werkstückträger eingesetzt werden, wobei ein separates Rücktransportsystem des Fertigungs-Werkstückträgers zum Anfang der Anlage verzichtet werden kann. In einer bevorzugten Ausführungsform des Verfahrens kann in der Vorkonfektionierung in der Beladestation ein automatisiertes Umsetzen der elektronischen Baugruppen und/oder der Werkstücke von einem bauteilspezifischen Transport-Werkstückträger auf einen anlagespezifischen Fertigungs-Werkstückträger erfolgen. Bevorzugt wird dafür der Transport-Werkstückträger in die Beladestation eingefahren, sodass ein Umsetzen innerhalb der Beladestation unter kontrollierbaren Bedingungen stattfinden kann. Derselbe Transport-Werkstückträger kann anschließend zum wieder Aufnehmen der elektronischen Baugruppen und/oder der Werkstücke dienen, nachdem diese die Fertigungsstation durchlaufen haben. Die Umsetzung der elektronischen Baugruppen und/oder der Werkstücke von dem Fertigungs-Werkstückträger auf den Transport-Werkstückträger kann in einer Entladestation durchgeführt werden. Der Fertigungs-Werkstückträger kann Bauteile mehrerer Transport-Werkstückträger aufnehmen.

In einer bevorzugten Ausführungsform des Verfahrens kann in einer Entladestation nach Durchlaufen der elektronischen Baugruppen und/oder der Werkstücke durch die Fertigungsstation, insbesondere vor einem automatisierten Rückführen des Fertigungs-Werkstückträgers von der Beladestation zur Entladestation, ein Entladen der elektronischen Baugruppen und/oder der Werkstücke von dem Fertigungs-Werkstückträger auf den Transport-Werkstückträger erfolgen. Bevorzugt können in insbesondere gleichen Zeitabständen Fertigungs-Werkstückträger in der Entladestation eintreffen, die jeweils entladen werden. Das Entladen der elektronischen Baugruppen und/oder der Werkstücke von einem Fertigungs-Werkstückträger kann auf einen Transport-Werkstückträger erfolgen, oder auch auf mehrere Transport-Werkstückträger.

In einer weiteren bevorzugten Ausführungsform kann in der Vorkonfektionierung zumindest ein automatisiertes Aufbringen zumindest einer Prozessabdeckung, insbesondere ein Auflegen zumindest einer Maske und/oder zumindest einer Folie, auf die elektronischen Baugruppen und/oder die Werkstücke erfolgen. Bei der Prozessabdeckung kann es sich um eine Maske bzw. Abdeckmaske handeln, die auf die elektronischen Baugruppen und/oder Werkstücke, die auf dem Fertigungs-Werkstückträger angeordnet sind, automatisiert aufgelegt werden kann. Die Aufbringung kann über eine automatisierte Vorrichtung bzw. einen Automatisierungsroboter erfolgen. Bevorzugt kann die Prozessabdeckung zwischen einer Parkposition, insbesondere zum Zwischenlagern der Prozessabdeckung, und zwischen der Position auf dem Fertigungs-Werkstückträger hin und her bewegt bzw. verschoben werden. Des Weiteren gelten ebenso die bezüglich der Anlage genannten Merkmale.

In einer bevorzugten Ausführungsform des Verfahrens kann in der Beladestation in einer ersten Arbeitsposition auf die elektronischen Baugruppen und/oder die Werkstücke, die auf dem Fertigungs-Werkstückträger angeordnet sind, eine Maske als erste Prozessabdeckung automatisiert aufgelegt werden. Des Weiteren kann in einer zweiten Arbeitsposition in der Beladestation eine temperaturfeste Folie auf die Maske als zweite Prozessabdeckung, insbesondere für einen Sinterprozess, automatisiert aufgelegt werden. Optional kann zusätzlich eine weitere Ausgleichsfolie aufgelegt werden. Anschließend kann, insbesondere an einer dritten Arbeitsposition, ein Fixieren der Folie mit der Maske und dem Fertigungs-Werkstückträger automatisiert, bevorzugt mit einem Halterahmen, insbesondere Haltering, erfolgen. Bezüglich der Vorteile sowie weiterer Merkmal ist auf die Ausführungen bezüglich der Anlage verwiesen.

In einer bevorzugten Ausführungsform können in der Entladestation die Arbeitspositionen in umgekehrter Reihenfolge angeordnet sein und in umgekehrter Reihenfolge durchgeführt werden. Da insbesondere dieselben Schritte in der Entladestation komplementär durchgeführt werden, die auch in der Beladestation durchgeführt wurden, können die beiden Module bevorzugt baugleich, jedoch gespiegelt zueinander ausgebildet sein. Ebenso kann die Beladestation gleichzeitig als Entladestation dienen, sofern der Fertigungs-Bauteilträger nach Durchlaufen der Anlage zusammen mit den Bauteilen wieder an den Eingang der Anlage zurückgeführt wird.

In einer bevorzugten Ausführungsform kann das Rückführen des Fertigungs-Werkstückträgers in einer Ebene erfolgen, die unterhalb, oberhalb oder benachbart zu einer horizontalen Ebene angeordnet ist, in der der Fertigungs-Werkstückträger beim Beladen und/oder Entladen und die Fertigungsstation angeordnet ist. Bevorzugt erfolgt die Rückführung durch eine Hubeinheit mit einer Unterflurförderung, wobei der Fertigungs-Werkstückträger über die Hubeinheit vertikal um eine Ebene nach unten oder oben gefahren und anschließend über die Unterflurförderung in Richtung Entladestation befördert wird.

In einer bevorzugten Ausführungsform kann das Rückführen des Fertigungs-Werkstückträgers durch eine erste Transporteinheit erfolgen, und der Transport-Werkstückträger auf einer weiteren Transporteinheit angeordnet sein, die insbesondere automatisiert verfährt, wobei die erste Transporteinheit und die weitere Transporteinheit unabhängig voneinander, und insbesondere unter Umgehung der Fertigungsstation, verfahrbar sind. Unter Umgehung der Fertigungsstation ist eine Umgehung wie bereits bezüglich der Anlage erläutert zu verstehen. Des Weiteren gelten die gleichen Vorteile wie bereits bezüglich der Anlage erläutert.

In einer bevorzugten Ausführungsform kann der Transport-Werkstückträger eine elektronische Baugruppe und/oder ein Werkstück, und der Fertigungs-Werkstückträger mehr als zwei, bevorzugt mehr als fünf, insbesondere sieben oder mehr, im Speziellen vierundzwanzig oder mehr, elektronische Baugruppen und/oder Werkstücke aufnehmen. Somit kann beim Beladen und/oder Entladen der Fertigungs-Werkstückträger an einer Position in der Beladestation verweilen, bis die Transporteinheit den Fertigungs-Werkstückträger mit elektronischen Baugruppen und/oder Werkstücken voll beladen hat.

In einem Fügeprozess unter Prozessatmosphäre, z.B. einem Vakuumsintern oder Vakuumlöten bzw. Diffusionslöten unter Prozessatmosphäre benötigt der notwendige Auf- und Abbau des Vakuums bzw. der Prozessatmosphäre eine Prozesszeit, die zu einer zeitlichen Verzögerung in einer Fließfertigung führt. Die Verzögerung wird bedingt durch ein Öffnen und Schließen von gasdichten Schleusen, dem Auf-und Abbau der Prozessatmosphäre in der oder den Prozesskammern sowie den Aufheiz- und Abkühlvorgängen. Durch eine hohe Anzahl von in einem Werkstückträger sammelbaren Werkstücken kann in der übrigen Fließfertigung weiterhin eine hohe Durchsatzgeschwindigkeit erreicht werden, wobei auch ein relativ zeitintensiver Löt- oder Sinterverfahren unter Prozessatmosphäre parallel eine hohe Zahl Werkstücke gleichzeitig verbinden kann. Es ist weiterhin möglich, dass der Transport-Werkstückträger mehr als eine elektronische Baugruppe und/oder mehr als ein Werkstück aufnehmen kann. So kann eine Taktzeit bei der Fertigung, insbesondere bei einer Fließfertigung, erhöht werden. Die weitere Transporteinheit kann eine höhere Fördergeschwindigkeit des Transports der Transport-Werkstückträger als die erste Transporteinheit der Fertigungs-Werkstückträger aufweisen, insbesondere wenn ein Fertigungs-Werkstückträger Baugruppen mehrerer Transport-Werkstückträger aufnimmt.

In einer bevorzugten Ausführungsform kann in der Beladestation ein Auflegen einer Folie als Prozessabdeckung auf den Fertigungs-Werkstückträger mit den elektronischen Baugruppen und/oder den Werkstücken erfolgen, wobei die Folie entweder eine neue Folie oder eine in einem vorherigen Durchgang des Verfahrens bereits verwendete Folie sein kann. So kann eine bereits verwendete Folie wiederverwendet werden, sodass Material eingespart werden kann. Die Folie kann zur Wiederverwendung von der Entladestation zur Beladestation zurückgeführt werden, insbesondere zusammen mit dem Fertigungs-Werkstückträger zurück zur Beladestation transportiert und dort neu verwendet werden. Ebenso kann die Folie direkt nach dem Entnehmen auf einen Folienstapel aufgelegt werden, wobei der komplette Folienstapel nach Aufnahme einer gewissen Anzahl an Folien zur Beladestation zurückgeführt werden kann. Dies kann über eine Verfahreinheit erfolgen, die bevorzug parallel zu einem Verfahrweg der Fertigungs-Werkstückträger zwischen der Beladestation, der Fertigungsstation und insbesondere der Entladestation verläuft. Vorzugsweise können bereits genutzte Folien durch eine Reinigungseinheit vor einer nächsten Verwendung gereinigt werden.

In einer bevorzugten Ausführungsform kann die Folie mit einem Folienumsetzer von einem Folienstapel entnommen und auf die elektronischen Baugruppen und/oder die Werkstücke aufgelegt werden, wobei der Folienstapel schrittweise in Richtung einer Oberseite des Folienstapels nach oben verfahren wird, sodass die jeweils oberste Folie mit dem Folienumsetzer erreichbar ist. Für den Folienumsetzer gelten die bereits erläuterten Merkmale und Vorteile bezüglich der Anlage sowie der erfindungsgemäßen Folienumsetzereinheit analog. Bevorzugt wird im Rahmen der Entnahme automatisch geprüft, dass nur eine Folie, oder eine vorbestimmte Anzahl von Folien entnommen wird. Dies kann beispielsweise optisch durch Messung einer Transparenz der entnommenen Folie oder des entnommenen Folienstapels und Vergleich mit Referenztransparenzwerten erfolgen. Alternativ oder zusätzlich kann die Dicke der entnommenen Folie bzw. des entnommenen Folienstapels bestimmt werden. Somit kann sichergestellt werden, dass zum einen die richtige Folie entnommen und zum anderen nur eine bzw. eine gewünschte Anzahl von Folien entnommen wird. Beispielsweise kann mittels eines hochpräzisen digitalen Messtasters die Dicke von beliebigen Folienarten sicher und schnell gemessen werden. Dies kann farbunabhängig und für transparente oder opake Folien, auch bei gewellten oder planen Folien eingesetzt werden. So kann beispielsweise eine Messposition am Rand bestimmt werden, und eine Folienstapelhöhe vor und nach der Entnahme oder die Dicke der Folie auf einer Referenzebene bestimmt werden. So kann beispielsweise ein Messtaster mit 1µm Genauigkeit, wie z.B. ein Keyence GT2 digitaler Messtaster eingesetzt werden. Bei Verwendung von Messtastern kann von einer hohen Präzision bzw. hoher Wiederholgenauigkeit ausgegangen werden. Wenn das Messobjekt auf keinen Fall verkratzt werden darf, können schonende Modelle oder verschiedene Spindelspitzen verwendet werden. Es sind hohe Lebensdauer mit über 20 Millionen Zyklen im Dauereinsatz und automatische Berechnung mit mehreren Messtastern möglich.

In einer bevorzugten Ausführungsform kann der Folienstapel nach einer gewissen Anzahl an entnommenen Folien um einen Hub von 5 mm bis 15 mm, insbesondere 10 mm, nach oben verfahren werden, wobei insbesondere nach 5 bis 10 entnommenen Folien der Folienstapel nach oben verfahren wird. So kann der Folienumsetzer gezielt eine jeweils oberste Folie des Folienstapels greifen, auch wenn der Folienstapel über einen Zeitraum eine unterschiedliche Anzahl an Folien aufweist.

In einer bevorzugten Ausführungsform kann vor dem Auflegen der Folie auf den Fertigungs-Werkstückträger mit den elektronischen Baugruppen und/oder den Werkstücken ein automatisiertes Reinigen der Folie mittels einer Reinigungseinheit erfolgen. Bevorzugt kann jede Folie vor dem Auflegen auf den Fertigungs-Werkstückträger mit den elektronischen Baugruppen und/oder Werkstücken der Reinigungseinheit zugeführt werden. Die Reinigungseinheit befindet sich dafür bevorzugt innerhalb eines geschlossenen Raumes, insbesondere eines Reinraums, in dem das Verfahren durchgeführt wird.

In einer bevorzugten Ausführungsform kann in der Reinigungseinheit die Folie elektrostatisch entladen werden und anschließend können Verunreinigungen durch Abblasen mit Druckluft und / oder Unterdruck entfernt werden. Die Reinigungseinheit kann beispielweise eine berührungslose Oberflächenreinigung durchführen. So können Verschmutzungen von dreidimensionalen oder strukturierten Oberflächen vorteilhaft beseitigt werden. Beispielsweise können durch eine pulsierende und hochturbulente Luftströmung Verunreinigungen entfernt werden. Insbesondere können unter Verwendung von Druckluft und/oder Unterdruck bis zum Vakuum und/oder ionisierter Luft, insbesondere in dieser Reihenfolge, positive sowie negative Ladungen in die Folie eingebracht werden. Dadurch kann vorteilhafterweise ein Haften zwischen einzelnen Folien weiter unterstützend vermieden werden.

In einer bevorzugten Ausführungsform können zumindest zwei oder auch mehrere Folienstapel nebeneinander angeordnet sein, wobei ein zweiter oder ein weiterer Folienstapel an eine Position eines ersten oder vorhergehenden Folienstapels bewegt wird, sobald der erste bzw. vorhergehende Folienstapel keine Folien mehr enthält, sodass ein unterbrechungsfreier Verfahrensablauf gewährleistet wird. Auch können die verschiedenen Folienstapel unterschiedliche Folien für verschiedene Werkstücke aufnehmen, so dass eine Fließfertigung von pro Werkstückträger verschiedenen Werkstücken möglich ist. Während Folien von dem ersten Folienstapel entnommen werden, kann der zweite Folienstapel nachgefüllt werden, oder andersherum. Ein Folienstapel kann beispielsweise Folien enthalten, die für eine Produktion bzw. Fertigung mit dem Verfahren über einen Zeitraum von 24 Stunden ausreichen. Ebenso sind andere Zeiträume beziehungsweise anders dimensionierte Folienstapel denkbar. Denkbar ist auch, dass in einem Folienstapel eine vorbestimmte Reihenfolge verschiedener Folien synchron zu einer geplanten Bearbeitungsreihenfolge von z.B. verschiedenen Werkstücken enthalten ist.

In einer bevorzugten Ausführungsform des Verfahrens kann eine lagerichtige Ausrichtung der Baugruppen und/oder der Werkstücke zumindest in dem Fertigungs-Werkstückträger optisch erfasst und protokolliert werden. Hierzu kann eine Inspektionseinrichtung vorgesehen sein, die mittels zumindest einer Inspektionskamera eine exakte Lage und Ausrichtung eines Werkstücks im Fertigungs-Werkstückträger erfassen und in Kombination mit einem Automatisierungsroboters korrigieren kann. Durch die Inspektionseinrichtung kann ein Automatisierungsroboter, der ein Einsetzen oder Korrektur der Lage der Werkstücke in dem Fertigungs-Werkstückträger vornimmt, korrigiert werden. Insbesondere kann bei einem Umsetzen von Werkstücken von einem Transport-Werkstückträger in einem Fertigungs-Werkstückträger eine Drehausrichtung und exakte Lage überprüft und korrigiert werden. Denn beim Verbinden der Werkstücke, insbesondere Sintern oder Diffusionslöten ist eine exakte Ausrichtung höchstwesentlich und kann durch die optische Inspektionseinrichtung sichergestellt und protokolliert werden. Hierzu können auf dem Fertigungs-Werkstückträger eine oder mehrere optische Referenzmarken zur vereinfachten Erfassung durch die Inspektionseinrichtung vorgesehen sein.

Die beschriebenen Merkmale sowie Vorteile gelten ebenso für die erfindungsgemäße Anlage, die erfindungsgemäße Folienumsetzereinheit sowie für das erfindungsgemäße Verfahren. Dabei können die Merkmale verschieden untereinander kombiniert werden.

### ZEICHNUNGEN

Weitere Vorteile ergeben sich aus der vorliegenden Zeichnungen und Zeichnungsbeschreibungen. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigt:
- **Fig. 1**: eine Ausführungsform einer erfindungsgemäßen Anlage zum Verbinden von elektronischen Baugruppen und/oder Fertigen von Werkstücken mit mehreren Modulen;
- **Fig. 2**: die Anlage aus Fig. 1 in einer Draufsicht;
- **Fig. 3**: eine Ausführungsform eines Moduls einer erfindungsgemäßen Anlage, das als Beladestation ausgebildet ist;
- **Fig. 4**: das Modul aus Fig. 3 in einer Draufsicht mit der Darstellung unterschiedlicher Arbeitspositionen und eine Ausführungsform einer weiteren Transporteinheit;
- **Fig. 5**: ein Ablaufplan möglicher unterschiedlicher Arbeitsschritte in der Beladestation aus Fig. 4;
- **Fig. 6**: eine Ausführungsform eines Moduls einer erfindungsgemäßen Anlage, das als Entladestation ausgebildet ist;
- **Fig. 7**: das Modul aus Fig. 6 in einer Draufsicht mit der Darstellung unterschiedlicher Arbeitspositionen und eine Ausführungsform einer Transporthubeinheit;
- **Fig. 8**: ein Ablaufplan möglicher unterschiedlicher Arbeitsschritte in der Entladestation aus Fig. 7;
- **Fig. 9**: eine Ausführungsform einer erfindungsgemäßen Folienumsetzereinheit mit zwei Folienumsetzern mit Darstellung von zwei Folienstapeln;
- **Fig. 10**: die Folienumsetzereinheit aus Fig. 9 in einer Draufsicht;
- **Fig. 11**: ein Ablaufplan möglicher unterschiedlicher Arbeitsschritte in der Folienumsetzereinheit aus Fig. 10;
- **Fig. 12**: eine Ausführungsform eines Höhenausgleichssystems eines Folienstapels und eines Folienumsetzers.;
- **Fig. 13**: eine weitere Ausführungsform einer Beladestation in einer Draufsicht mit einer Folienumsetzereinheit und einer optischen Inspektionseinheit;
- **Fig. 14**: eine weitere Ausführungsform einer Entladestation mit einer optischen Inspektionseinheit;
- **Fig. 15a,b**: eine Draufsicht auf eine Ausführungsform eines FertigungsWerkstückträger mit optischen Referenzmarken;
- **Fig. 16**: perspektivisch eine Kombination eines Fertigungs-Werkstückträger mit Werkstücken, Prozessabdeckung und Halterahmen;
- **Fig. 17**: eine weitere Ausführungsform einer erfindungsgemäßen Anlage zum Verbinden von elektronischen Baugruppen und/oder Fertigen von Werkstücken mit mehreren Modulen;
- **Fig. 18**: die Anlage aus Fig. 17 in einer Frontansicht;
- **Fig. 19**: eine weitere Ausführungsform eines Moduls einer erfindungsgemäβen Anlage, das als Beladestation ausgebildet ist;
- **Fig. 20**: das Modul aus Fig. 19 in einer Draufsicht mit der Darstellung unterschiedlicher Arbeitspositionen;
- **Fig. 21**: eine weitere Ausführungsform eines Moduls einer erfindungsgemäβen Anlage, das als Entladestation ausgebildet ist;
- **Fig. 22**: das Modul aus Fig. 21 in einer Draufsicht mit der Darstellung unterschiedlicher Arbeitspositionen;
- **Fig. 23**: eine Beladestation einer weiteren Ausführungsform für eine Sinterbearbeitung;
- **Fig. 24**: eine Entladestation einer weiteren Ausführungsform für eine Sinterbearbeitung.

In den Figuren sind gleiche oder gleichartige Komponenten mit gleichen Bezeichnungen beziffert.

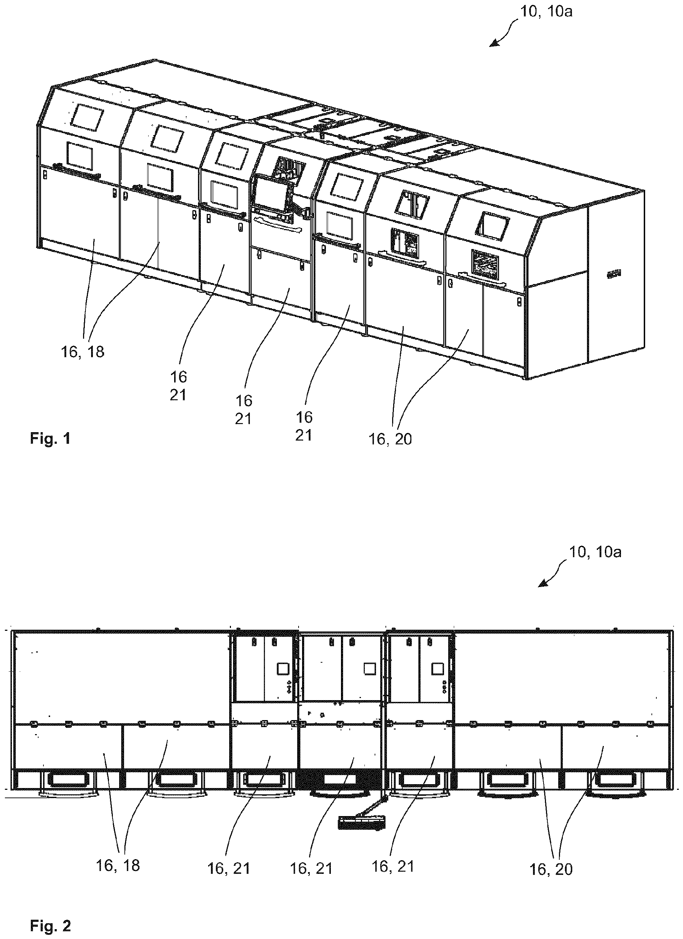

**Fig. 1** zeigt eine Ausführungsform einer erfindungsgemäßen Anlage 10 zum Verbinden von elektronischen Baugruppen 12 und/oder Werkstücken 14. Die Anlage 10 weist mehrere Module 16 auf. Eine derartige Anlage 10 kann beispielsweise eine Sinter- oder Lötanlage 10a ausbilden. In diesem Zusammenhang kann unter Sintern, wie bereits erwähnt, ebenso das Herstellen oder Verändern von Werkstoffen unter hohem Druck sowie Temperatur, wie auch das Verbinden von mehreren Elementen als Fügeprozess verstanden werden. Durch eine derartige Anlage 10 können beispielsweise temperaturbeständige Sinterverbindungen oder Lötverbindungen hergestellt werden. In dieser Ausführungsform zeigt die Anlage 10 fünf Module 16. Das erste Modul 16 ist als Beladestation 18 ausgebildet. Daran schließt sich eine Fertigungsstation 21 mit beispielsweise einem Vorheizmodul, einem Sintermodul und einem Abkühlmodul an. Das Modul 16 am rechten Ende der Anlage 10 ist als Entladestation 20 ausgebildet. Zur Ausbildung eines Reinraums, insbesondere eines ISO 5 Reinraums, ist die Anlage bevorzugt als geschlossene Kammer und/oder gasdicht ausgebildet. Bevorzugt sind daher die Module 16 untereinander verbunden, jedoch gegenüber äußeren Einflüssen in einem gemeinsamen Gehäuse geschützt.

**Fig. 2** zeigt die Anlage 10 aus Fig. 1 in einer Draufsicht. Dabei sind die einzelnen Kammern der Module 16 erkennbar. Die Anlage 10 ist insgesamt länglich ausgebildet, sodass ein Fertigungs-Werkstückträger 22 mit elektronischen Baugruppen 12 und/oder Werkstücken 14 in einer Richtung, insbesondere auf einer geraden Linie bzw. einem geradlinigen Fahrweg, die Anlage 10 durchlaufen kann. Die elektronischen Baugruppen 12 und/oder Werkstücke 14 können beispielsweise von der in der Darstellung linken Seite der Anlage 10 dieser zugeführt werden. Anschließend können die elektronischen Baugruppen 12 und/oder Werkstücke 14 auf der in der Darstellung rechten Seite aus der Anlage 10 wieder entnommen werden.

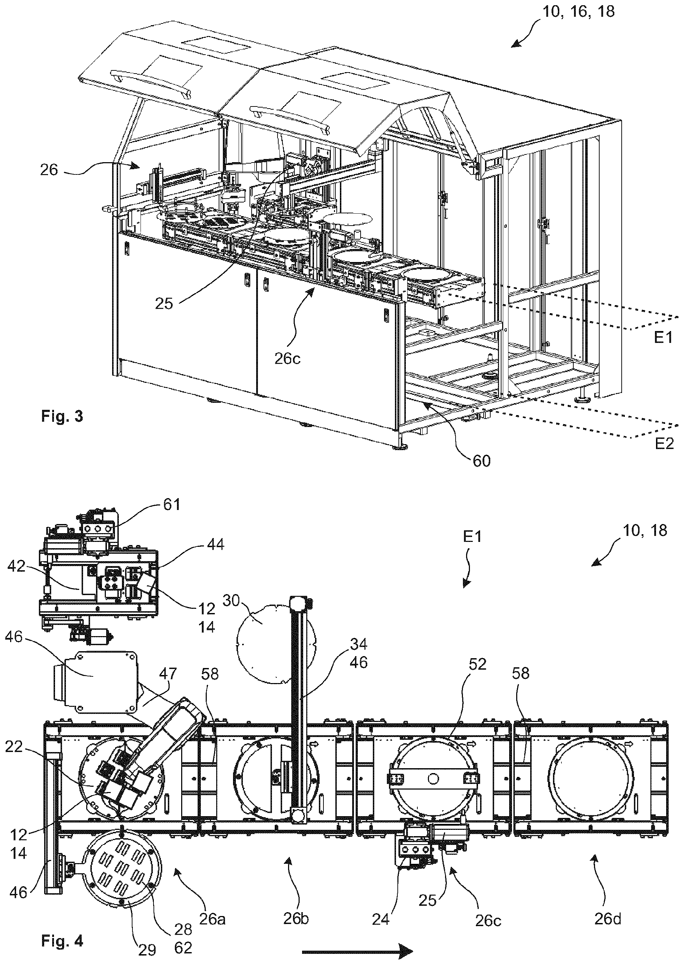

**Fig. 3** zeigt ein Modul 16 einer erfindungsgemäßen Anlage 10, das als Beladestation 18 ausgebildet ist. Das Gehäuse der Beladestation 18 ist auf der Vorderseite geöffnet dargestellt. Dadurch sind einzelne Arbeitspositionen 26 der Beladestation 18 erkennbar. Diese sind in einer oberen bzw. mittleren Ebene E1 innerhalb der Beladestation 18 angeordnet. Unterhalb dieser Ebene E1 ist eine Unterflurfördereinheit 60 einer Transporteinheit 24 erkennbar, die in Ebene E2 angeordnet ist. Mit dieser können die Fertigungs-Werkstückträger 22 rückgeführt werden. Dies bedeutet, dass die Fertigungs-Werkstückträger 22 die Arbeitspositionen 26 in einer gegenläufigen Richtung bezüglich einer Transportrichtung der Transporteinheit 24 durchlaufen. In dieser Darstellung ist eine Hubeinheit 25 der Transporteinheit 24 in Ebene E1 erkennbar. Diese ist mit der Unterflurfördereinheit 60 verbunden. Um die Fertigungs-Werkstückträger 22 von der unteren Ebene E2, in der die Unterflurfördereinheit 60 angeordnet ist, in die obere Ebene E1, in der die Arbeitspositionen 26 angeordnet sind, zu befördern, kann die Hubeinheit 25 eingesetzt werden. Die Hubeinheit 25 kann durch einen Hub von Ebene E1 in Ebene E2, oder andersherum, die Fertigungs-Werkstückträger 22 befördern. In dieser Ausführungsform ist die Hubeinheit 25 an der Arbeitsposition 26c angeordnet. Folglich können die Fertigungs-Werkstückträger 22 an diese Arbeitsposition 26c geführt werden. In einer davon abweichen Ausführungsform kann durch die Hubeinheit 25 der Fertigungs-Werkstückträger 22 an jede beliebige Arbeitsposition 26a- 26d rückgeführt werden. Somit ist ein geschlossener Transportkreislauf der Fertigungs-Werkstückträger 22 durch die Fertigungsstation 21 gegeben.

In **Fig. 4** ist die Beladestation 18 aus Fig. 3 in einer Draufsicht mit der Darstellung unterschiedlicher Arbeitspositionen 26 und mit einer Ausführungsform einer zweiten Transporteinheit 42 dargestellt. Dargestellt ist die obere Ebene E1 in einer Draufsicht. Aus den Figs. 3 und 4 ist ersichtlich, dass die Arbeitspositionen 26a-26d auf dieser oberen Ebene E1 angeordnet sind.

In Arbeitsposition 26a erfolgt ein Auflegen der elektronischen Baugruppen 12 und/oder Werkstücke 14 von einem Transport-Werkstückträger 44 auf einen Fertigungs-Werkstückträger 22. Dies kann auch als Vorkonfektionierung bezüglich des Verfahrens 100 bezeichnet werden. Die elektronischen Baugruppen 12 und/oder Werkstücken14 können mit einem Automatisierungsroboter 46, insbesondere einem Roboterarm 47, von dem Transport-Werkstückträger 44, der sich auf einer zweiten Transporteinheit 42 befindet, auf den Fertigungs-Werkstückträger 22 umgesetzt werden. Die zweite Transporteinheit 42 kann sich innerhalb der Anlage 10 befinden, jedoch unabhängig von den Arbeitspositionen 26 sowie insbesondere unabhängig von der Beladestation 18 bewegen. Dadurch kann die zweite Transporteinheit 42 beispielsweise von der Beladestation 18 zu einer Entladestation 20 (in dieser Darstellung nicht dargestellt) automatisiert Verfahren, um dort die elektronischen Baugruppen 12 und/oder die Werkstücke 14 wieder aufzunehmen. Die zweite Transporteinheit 42 kann ein oder mehrere elektronische Baugruppen 12 und/oder Werkstücke 14 aufnehmen. Die zweite Transporteinheit 42 umfasst eine Hubeinheit 61, durch die ein entleerter Transport-Werkstückträger 44 von einer ersten Transportebene E1 auf eine zweite Transportebene E2 abgesenkt werden kann. Hier können die leeren Transport-Werkstückträger 44 durch die Anlage 10 bis zur Entladestation 20 unter Umgehung von atmosphärendichten Anlagemodulen 16 verfahren werden, um dort wieder Werkstücke 14 aus den Fertigungs-Werkstückträgern 22 aufzunehmen. Hierzu kann die Entladestation 20 eine weitere Hubeinheit 61 aufweisen, um die Transport-Werkstückträger von Ebene E2 auf Ebene E1 heraufzuheben.

Des Weiteren erfolgt in der Arbeitsposition 26a ein Auflegen einer Prozessabdeckung 62, insbesondere das Auflegen einer Maske 28. Die Prozessabdeckung 62 kann Aussparungen aufweisen, sodass an gezielten Positionen der Aussparungen Sinterverbindungen bzw. Lötverbindungen hergestellt werden können. Die Prozessabdeckung 62 kann sich zunächst auf einer Parkposition 29 befinden. Von dieser Parkposition 29, die neben der Arbeitsposition 26a angeordnet ist, kann die Prozessabdeckung 62 auf den Fertigungs-Werkstückträger 22 mit den elektronischen Baugruppen 12 und/oder den Werkstücken 14 automatisiert bewegt werden. Dies kann beispielsweise durch eine Art Schiene sowie einen Greifer bzw. Rahmen erfolgen, die automatisiert gesteuert werden. Ebenso kann das Aufsetzen der Prozessabdeckung 62 über einen Automatisierungsroboter 46 erfolgen. Dabei kann es sich um denselben Automatisierungsroboter 46 handeln, der auch zum Aufsetzen der elektronischen Baugruppen 12 und/oder der Werkstücke 14 verwendet wird. Des Weiteren kann ein zweiter, davon unabhängiger Automatisierungsroboter 47 (nicht dargestellt) eingesetzt werden. Nach Durchführung dieser Schritte wird der Fertigungs-Werkstückträger 22, mit den elektronischen Baugruppen 12 und/oder den Werkstücken 14 sowie mit der Prozessabdeckung 62, automatisiert zu der nächsten Arbeitsposition sechsten 26b bewegt. Dies kann über eine Verfahreinheit, beispielsweise eine Art Fließband, erfolgen.

In der Arbeitsposition 26b erfolgt in dieser Ausführungsform ein Auflegen einer Folie 30 auf den bereits zum Teil vorkonfektionierten Fertigungs-Werkstückträger 22. Die Folie 30 kann sich ebenso neben der Arbeitsposition 26b in einer Art Parkposition befinden, bevor diese zur Arbeitsposition 26b verschoben wird. Dies kann ebenso über eine Schiene mit einem Greifer oder eine andersartige Aufbringungsvorrichtung erfolgen. Anschließend wird der weiter vorkonfektionierte Fertigungs-Werkstückträger 22 mit der Folie 30 zu der nächsten Arbeitsposition 26c automatisiert bewegt.

In Arbeitsposition 26c wird durch einen Haltering 52 die Folie 30 auf dem Fertigungs-Werkstückträger 22 fixiert. Dies erfolgt ebenso automatisiert, beispielsweise über eine computergesteuerte Aktuatorvorrichtung oder über einen weiteren Automatisierungsroboter 46. In der Arbeitsposition 26c ist außerdem die Hubeinheit 25 der Transporteinheit 24 erkennbar. Die Hubeinheit 25 kann die Fertigungs-Werkstückträger 22 mit aufgebrachter Folie 30 sowie der Prozessabdeckung 62 von einem weiteren Modul 16, beispielsweise der Entladestation 20, zu der Beladestation 18 zu der Arbeitsposition 26c zurückführen. Es ist ebenso denkbar, dass der Fertigungs-Werkstückträger 22 über die Transporteinheit 24 zu einer anderen Arbeitsposition 26 zurückgeführt wird (hier nicht dargestellt).

Die Arbeitsposition 26d dient als Pufferposition. Dort könnte ein weiterer Arbeitsschritt erfolgen, der notwendig ist, bevor der vorkonfektionierte Fertigungs-Werkstückträger 22 in ein weiteres Modul 16, insbesondere der Fertigungsstation 21, automatisiert Verfahren wird.

Über die Hubeinheit 25 und eine Unterflurfördereinheit 60 (in dieser Draufsicht nicht sichtbar) kann der Fertigungs-Werkstückträger 22 in eine Ebene E2 unterhalb der in Fig. 4 dargestellten Ebene verfahren und an zumindest eine der Arbeitspositionen 26a-26d rückgeführt werden.

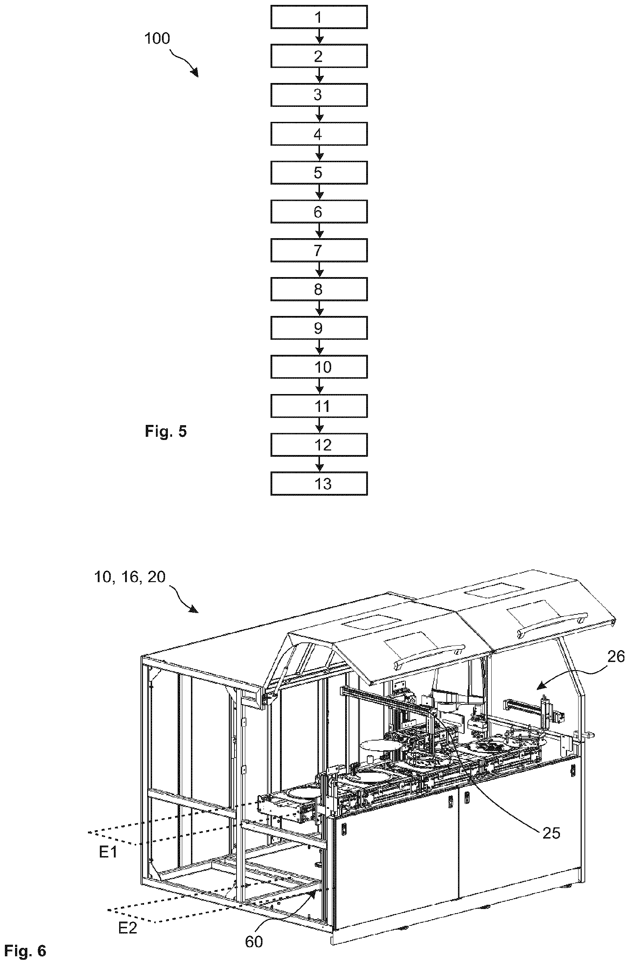

**Fig. 5** zeigt eine Ausführungsform eines möglichen Ablaufs der unterschiedlichen Arbeitsschritte 1 bis 13 eines Verfahrens 100 in der Beladestation 18 aus Fig. 4. In Schritt 1 wird zunächst der Fertigungs-Werkstückträger 22 über eine Hubeinheit 25 von der Unterflurfördereinheit 60 von der Entladestation 20 geholt. Auf dem Fertigungs-Werkstückträger 22 kann bei der Rückführung eine Prozessabdeckung 62 sowie ein Haltering 52 angeordnet sein. Daher kann in Schritt 1 der Fertigungs-Werkstückträger 22 zunächst zu der Arbeitsposition 26c geführt werden. Die Durchführung der kompletten Arbeitsschritte in Schritt 1 kann beispielsweise eine Zeit von 19 Sekunden dauern. In Schritt 2 kann schließlich an Arbeitsposition 26c der Haltering 52 entnommen werden. Dies kann beispielsweise 4 Sekunden dauern. In Schritt 3 kann ein Transport des Fertigungs-Werkstückträgers 22 von der Arbeitsposition 26c zu der Arbeitsposition 26a erfolgen, mit einer Zeitdauer von beispielsweise 15 Sekunden. In Schritt 4 kann schließlich die Prozessabdeckung 62 automatisiert gegriffen und seitlich auf einer Parkposition 29 abgelegt werden. Dies kann beispielsweise 4 Sekunden dauern. In Schritt 5 können die elektronischen Baugruppen 12 und/oder die Werkstücke 14 mit einem Automatisierungsroboter 46 in den Fertigungs-Werkstückträger 22 abgelegt werden. Dabei können beispielsweise alle 5 Sekunden 7 elektronische Baugruppen 12 und/oder Werkstücke 14 bewegt werden. Die Durchführung der Arbeitsschritte in Schritt 5 kann daher beispielsweise 35 Sekunden betragen. In Schritt 6 kann die zweite Transporteinheit 42 zu einer Entladestation 20 automatisiert Verfahren. Dies kann Beispielsweise auch Unterflur erfolgen, insbesondere mit einer Zeitdauer von beispielsweise 100 Sekunden. In Schritt 7 kann die Prozessabdeckung 62 zurück auf den Fertigungs-Werkstückträger 22 gelegt werden, mit einer Zeitdauer von beispielsweise 4 Sekunden. In Schritt 8 kann der Fertigungs-Werkstückträger 22 von der Arbeitsposition 26a zur Arbeitsposition 26b verfahren werden, mit einer Zeitdauer von beispielsweise 7 Sekunden. In Schritt 9 kann eine Folie 30, insbesondere eine temperaturfeste Folie, auf den Fertigungs-Werkstückträger 22 gelegt werden, mit einer Zeitdauer von beispielsweise 4 Sekunden. In Schritt 10 kann der Fertigungs-Werkstückträger 22 von der Arbeitsposition 26b auf die Arbeitsposition 26c bewegt werden, insbesondere mit einer Zeitdauer von beispielsweise 7 Sekunden. In Schritt 11 kann der Haltering 52 zurück auf den Fertigungs-Werkstückträger 22 gelegt werden, insbesondere mit einer Zeitdauer von beispielsweise 4 Sekunden. In Schritt 12 kann der Fertigungs-Werkstückträger 22 von der Arbeitsposition 26c zur Arbeitsposition 26d bewegt werden, insbesondere mit einer Zeitdauer von beispielsweise 7 Sekunden. Die Arbeitsposition 26d kann eine Pufferposition ausbilden. In Schritt 13 kann der Fertigungs-Werkstückträger 22 schließlich von der Arbeitsposition 26d in ein weiteres Modul 16, beispielsweise ein Vorheizmodul der Fertigungsstation 21, transportiert werden. Dies kann in einem Zeitrahmen von beispielsweise 10 Sekunden durchgeführt werden. Die Gesamtzeit der Durchführung der Schritte 1-13 kann daher in einem Zeitraum von beispielsweise 80-120 Sekunden, insbesondere in einem Zeitraum von 100-110 Sekunden erfolgen. Selbstverständlich kann die Durchführung auch in einem davon abweichenden Zeitraum erfolgen, wobei der Zeitraum um einiges länger bzw. auch um einiges kürzer sein kann. Bevorzugt wird zu dem Zeitraum die Zeit für die Durchführung der Schritte 6 sowie 13 nicht addiert, da diese Schritte parallel zur Durchführung der Schritte 1-5 sowie 7-12 erfolgen können.

**Fig. 6** zeigt ein Modul 16 einer erfindungsgemäßen Anlage 10, das als Entladestation 20 ausgebildet ist. Die Arbeitspositionen 26 der Entladestation 20 sind in umgekehrter Reihenfolge bezüglich der Arbeitspositionen 26a-26d der Beladestation 18 in Fig. 3 angeordnet. Dargestellt ist ebenso die obere Ebene E1, in welcher die Arbeitsposition 26a-26d angeordnet sind, sowie die untere Ebene E2, die zur Rückführung des Fertigungs-Werkstückträgers 22, insbesondere mithilfe einer Unterflurfördereinheit 60, dient. Die Entladestation 20 kann funktionell komplementär zur Beladestation 18 arbeiten.

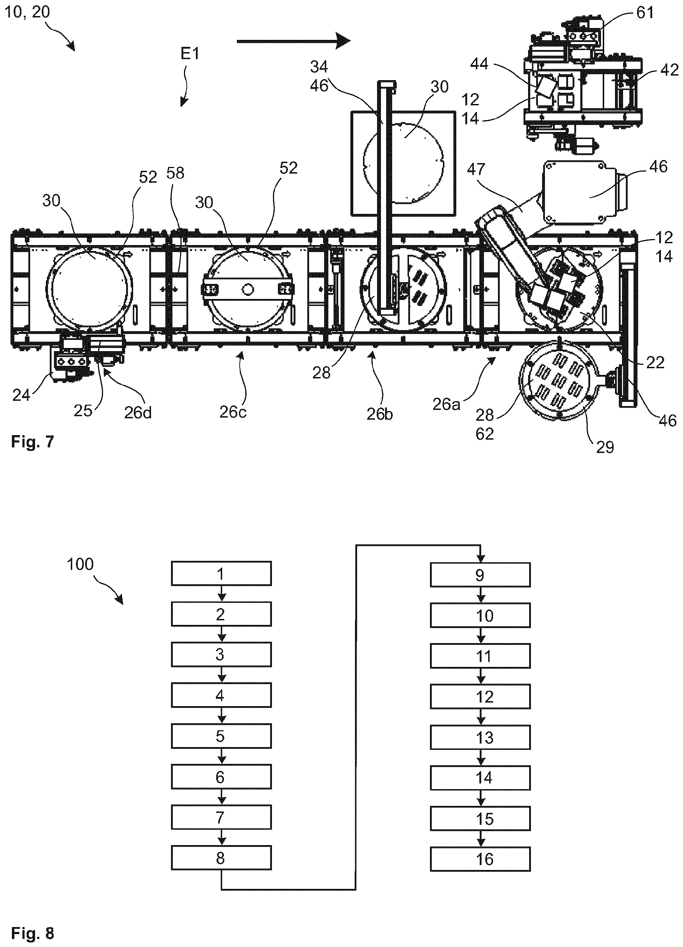

In **Fig. 7** ist das Modul 16 aus Fig. 6 in einer Draufsicht mit der Darstellung unterschiedlicher Arbeitspositionen 26 in der oberen Ebene E1 und eine Ausführungsform einer zweiten Transporteinheit 42 dargestellt. Die Arbeitspositionen 26a-26d sind gespiegelt, d.h. funktionell komplementär zu den Arbeitspositionen 26a-26d in der Beladestation 18 angeordnet. Folglich können die Arbeitsschritte, die in der Beladestation 18 nacheinander durchgeführt wurden, in entgegengesetzter Reihenfolge in der Entladestation 20 durchgeführt werden.. Durch eine weitere Hubeinheit 61 werden leere Transport-Werkstückträger, die von der Beladestation 18 zur Entladestation 20 transportiert wurden, von Ebene E2 auf Ebene E1 heraufgehoben, auf der verarbeitete Werkstücke 14 mittels des Automatisierungsroboters 62 von einem Fertigungs-Werkstückträger 22 umgesetzt werden.

**Fig. 8** zeigt einen möglichen Ablauf unterschiedlicher Arbeitsschritte einer Ausführungsform eines erfindungsgemäßen Verfahrens 100, durchgeführt in der Entladestation 20 aus Fig. 7 mit den Schritten 1 bis 16. In Schritt 1 kann der Fertigungs-Werkstückträger 22 von der Fertigungsstation 21, insbesondere einem Modul 16, das als Abkühlmodul ausgebildet ist, in die Entladestation 20 eingefahren werden. Dies kann automatisiert erfolgen, und beispielsweise in einem Zeitraum von 10 Sekunden durchgeführt werden. Der Fertigungs-Werkstückträger 22 befindet sich dann an der Arbeitsposition 26d, die als Pufferstation ausgebildet sein kann. In Schritt 2 kann der Fertigungs-Werkstückträger 22 von der Arbeitsposition 26d zur Arbeitsposition 26c transportiert werden, beispielsweise in einem Zeitraum von 7 Sekunden. In Schritt 3 kann der Haltering 52 automatisiert entnommen werden. Beispielsweise kann der Haltering 52 angehoben werden, was einen Zeitraum von insbesondere 4 Sekunden benötigt. In Schritt 4 kann der Fertigungs-Werkstückträger 22 von der Arbeitsposition 26c zur Arbeitsposition 26b verfahren werden, beispielsweise in einen Zeitraum von 7 Sekunden. In Schritt 5 kann die Prozessabdeckung 62 auf dem Fertigungs-Werkstückträger 22 gegriffen werden, beispielsweise durch eine Halteeinheit, insbesondere in einem Zeitraum von 3 Sekunden. Anschließend bzw. parallel kann in Schritt 6 die Folie 30, insbesondere die PDFE-Folie, gegriffen und abgezogen werden, insbesondere in einem Zeitraum von 4 Sekunden. Dies kann beispielsweise durch einen Folienumsetzer 34 erfolgen. In Schritt 7 kann die Prozessabdeckung 62 schließlich losgelassen werden, insbesondere benötigt dies einen Zeitraum von 3 Sekunden. In Schritt 8 kann der Fertigungs-Werkstückträger 22 von der Arbeitsposition 26b zur Arbeitsposition 26a verschoben werden, insbesondere automatisiert und in einem Zeitraum von 7 Sekunden. In Schritt 9 kann die Prozessabdeckung 62 schließlich gegriffen und seitlich auf einer Parkposition 29 abgelegt werden, insbesondere in einen Zeitraum von 4 Sekunden. In Schritt 10 können die elektronischen Baugruppen 12 und/oder die Werkstücke 14 mit einem Automatisierungsroboter 46 von dem Fertigungs-Werkstückträger 22 auf einen Transport-Werkstückträger 44 umgesetzt werden. Dabei können beispielsweise alle 5 Sekunden sieben elektronische Baugruppen 12 und/oder Werkstücke 14 bewegt werden, insbesondere in einem Zeitraum von 35 Sekunden. In Schritt 11 kann die Prozessabdeckung 62 schließlich zurück auf den Fertigungs-Werkstückträger 22 gelegt werden. Dies kann ebenso in der Arbeitsposition 26a erfolgen, und beispielsweise in einen Zeitraum von 4 Sekunden. In Schritt 12 kann der Fertigungs-Werkstückträger 22 von der Arbeitsposition 26a auf die Arbeitsposition 26c transportiert werden. Dies kann bevorzugt automatisiert erfolgen und in einem Zeitraum von beispielsweise 14 Sekunden. In dieser Arbeitsposition 26c kann in Schritt 13 der Haltering 52 zurück auf den Fertigungs-Werkstückträger 22 gelegt werden, insbesondere in einen Zeitraum von 4 Sekunden. Anschließend kann in Schritt 14 der Fertigungs-Werkstückträger 22 von der Arbeitsposition 26c auf die Arbeitsposition 26d transportiert werden, insbesondere in einem Zeitraum von 7 Sekunden. Anschließend kann in Schritt 15 der Fertigungs-Werkstückträger 22 auf die Transporteinheit 24 abgelegt werden, insbesondere über die Hubeinheit 25 auf die Unterflurfördereinheit 60 abgelegt werden. Dies kann einen Zeitraum von beispielsweise 19 Sekunden benötigen. In Schritt 16 kann über die Unterflurfördereinheit 60 schließlich eine Rückführung des Fertigungs-Werkstückträger 22 zur Beladestation 18 erfolgen. Der Fertigungs-Werkstückträger 22 kann zur Arbeitsposition 26c der Beladestation 18 rück geführt werden, an welcher zunächst der Haltering 52 entnommen werden kann. Das anschließende Verfahren 100, insbesondere mit den Schritten 1-13, wurde bereits anhand der Fig. 5 erläutert.

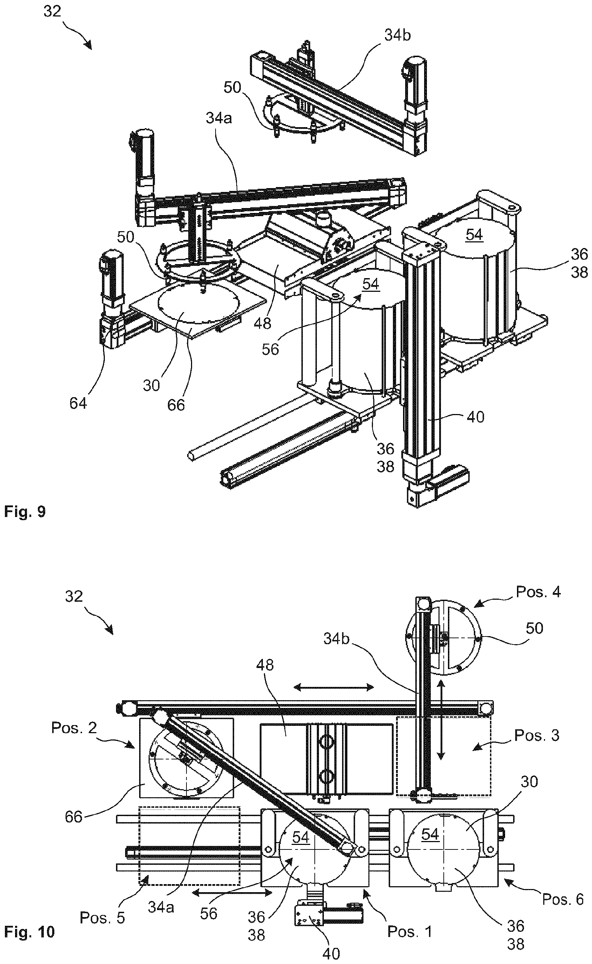

In **Fig. 9** ist eine Ausführungsform einer erfindungsgemäßen Folienumsetzereinheit 32 mit zwei Folienumsetzern 34 mit Darstellung von zwei Folienstapeln 36 dargestellt. Über einen Folienumsetzer 34 kann jeweils die oberste Folie 30 von einer Oberseite 54 eines Folienstapels 36 entnommen werden. Die Oberseite 54 dient als Entnahmefläche 56. Die Folienstapel 36 sind jeweils als ein Folienmagazin 38 ausgebildet.

Ist das erste Folienmagazin 38 (links in der Darstellung) leer, kann ein zweites Folienmagazin 38 an die Position des ersten Folienmagazins 38 verschoben werden. Das zweite Folienmagazin 38 kann die gleichen, aber auch anderen Typen von Folien aufnehmen. Dadurch kann ein kontinuierlicher Ablauf gewährleistet werden. Während Folien 30 aus dem zweiten Folienmagazin 38 entnommen werden, kann das erste Folienmagazin 38 nachgefüllt werden. Die Folienumsetzereinheit 32, insbesondere mit den Folienumsetzern 34 und den Folienmagazinen 38, kann beispielsweise in eine bestehende beliebige Anlage nachgerüstet werden. Ebenso kann das Absetzen und/oder Entnehmen der Folien 30 in der Arbeitsposition 26b der Beladestation 18 und/oder der Entladestation 20 der erfindungsgemäßen Anlage 10 durch eine derartige Folienumsetzereinheit 32 erfolgen.

In Fig. 9 ist ebenso eine Reinigungseinheit 48 dargestellt. Über den ersten Folienumsetzer 34a wird zunächst eine Folie 30 vom ersten Folienmagazin 38 entnommen und auf die Reinigungseinheit 48 aufgelegt. Nach dem Reinigen der Folie 30 wird die Folie 30 von der Reinigungseinheit 48 mit dem zweiten Folienumsetzer 34b entnommen und auf einen Fertigungs-Werkstückträger 22 aufgelegt. Bei der Reinigungseinheit 48 kann eine Linearreinigungseinheit 64 umfassen sein, oder es kann sich um ein berührungslos arbeitendes Oberflächenreinigungssystem handeln. Bei einer erfindungsgemäßen Anlage 10 bzw. bei einem erfindungsgemäßen Verfahren 100 kann durch eine Reinigungseinheit 48 eine Folie 30, insbesondere an die Arbeitsposition 26c der Beladestation 18 aus Figs. 3 und 4, zugeführt werden.

Über eine Folien-Hebeeinheit 40 kann der Folienstapel 36 vertikal nach oben geschoben werden. Dadurch kann sich die oberste Folie 30 des Folienstapels 36 zu jeder Situation an der im Wesentlichen gleichen Position befinden. Dadurch wird sichergestellt, dass der Folienumsetzer 34a die oberste Folie 30 des Folienstapels 36 unabhängig von der Anzahl der enthaltenen Folien 30 im Folienstapel 36 sicher entnehmen kann. Des Weiteren kann der Folienumsetzer 34 ein Höhenausgleichsystem 50 umfassen, durch welches Abweichungen der Position der obersten Folie 30 im Folienstapel 36 ausgeglichen werden können. Der Folienumsetzer 34 kann beispielsweise mit einem Greifer ausgebildet sein, wobei ein Aufnehmen der Folie 30 pneumatische und/oder über Vakuum, insbesondere über einen Vakuumsauger, erfolgen kann. Dadurch kann besonders vorteilhaft ein Auflegen sowie Reinigen der Folie 30 automatisiert, insbesondere vollautomatisiert, erfolgen. Ein händischer Eingriff ist zum Auflegen oder Entfernen der Folie 30 nicht notwendig, wodurch besonders vorteilhaft ein Reinraum, insbesondere ein ISO 5 Reinraum, ausgebildet werden kann.

**Fig. 10** zeigt die Folienumsetzereinheit 32 aus Fig. 9 in einer Draufsicht. Dieselben Bauteile sind mit denselben Bezugszeichen gekennzeichnet, sodass darauf nicht weiter eingegangen werden muss. In dieser Ansicht ist vorteilhaft erkennbar, dass sich die beiden Folienstapel 36 neben der Reinigungseinheit 48 befinden. Im oberen Bereich der Darstellung, d. h. neben der Reinigungseinheit 48, kann eine Folie 30 mithilfe des Folienumsetzer 34b auf einen Fertigungs-Werkstückträger 22 mit elektronischen Baugruppen 12 und/oder Werkstücken 14 (in dieser Darstellung nicht dargestellt) aufgelegt werden. Ein Fertigungs-Werkstückträger 22 könnte sich folglich neben der Reinigungseinheit 48 im oberen Bereich des Bildes befinden, wenn diese in einer Beladestation 18 angeordnet ist. Zur Sicherstellung, dass nur eine Folie und die richtige Folie entnommen wurde, kann an Pos. 3 ein Prüfen über ein mechanisches Dickenmesssystem, z.B. einen hochpräzischen digitalen Messtaster die Dicke der entnommenen Folie bestimmt werden. Dabei kann unabhängig vom Typ der Folie bestimmt werden, ob keine, eine oder mehrere Folien entnommen worden sind. Dabei kann der Folientaster an einem Randbereich die Foliendicke bestimmen, um die prozessrelevanten Bereiche z.B. beim Sintern unberührt zu lassen.

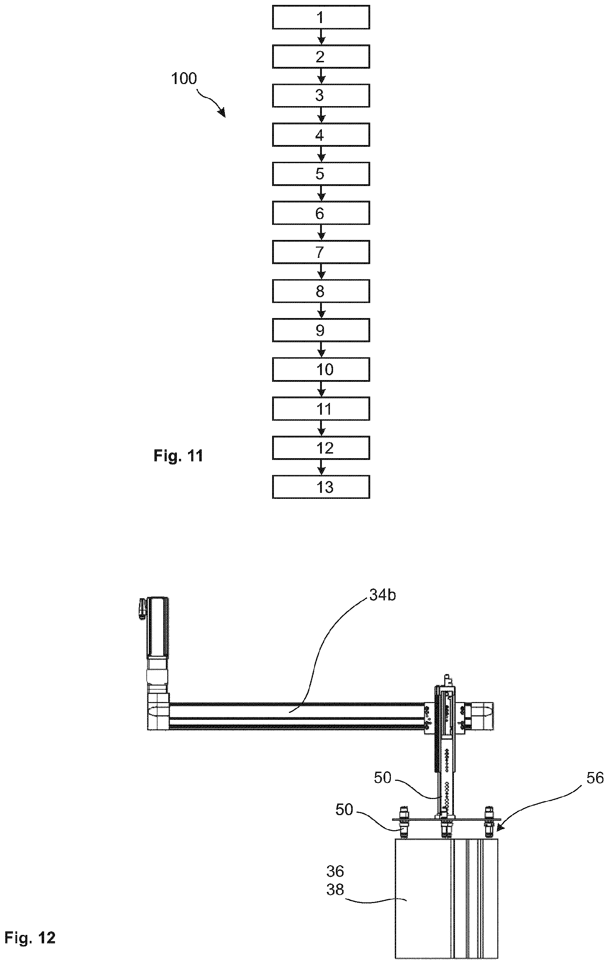

**Fig. 11** zeigt einen möglichen Ablauf unterschiedlicher Arbeitsschritte 1 bis 13 der Folienumsetzereinheit 32 aus Fig. 10. In Schritt 1 können einzelne Folien 30 von einem Folienstapel 36 an Position 1 entnommen und auf einen Folienträger 66 an Position 2 aufgelegt werden. In Schritt 2 kann der Folienträger 66 mit einer Folie 30 von Position 2 durch die Reinigungseinheit 48 auf Position 3 fahren. In Schritt 3 können schließlich die Folie 30 auf einen Fertigungs-Werkstückträger 22 (nicht dargestellt) aufgelegt werden, der sich an Position 4 befindet. In Schritt 4 kann der Folienträger 66, nun ohne eine Folie 30, von der Position 3 wieder zurück auf die Position 2 gefahren werden. In einem fünften Schritt können sich die Schritte 1-4 wiederholen. In Schritt 6 kann ein Anheben des Folienstapels 36 erfolgen, der sich an Position 1 befindet. Dies kann mit einer Folien-Hebeeinheit 40 erfolgen. Die Folien-Hebeeinheit 40 kann beispielsweise nach einem Verbrauch von 10 Folien 30, oder auch nach einem Absenken der Position der obersten Folie 30 um beispielsweise 10 mm, den kompletten Folienstapel 36 um dementsprechend 10 mm nach oben verfahren. Ein weiterer Höhenunterschied können direkt am Folienumsetzer 34 über ein Höhenausgleichsystem 50, beispielsweise durch einen Vakuumsauger-Halter, ausgeglichen werden. In Schritt 7 kann ein Nachfüllen bzw. Befüllen des Folienstapels 36 erfolgen, der sich an Position 6 befindet. Der Folienstapel 36 ist bevorzugt als Folienmagazin 38 ausgebildet. Das Nachfüllen kann insbesondere bei laufendem Betrieb der Folienumsetzereinheit 32, bzw. der Anlage 10 erfolgen. In Schritt 8 kann das leere Folienmagazin 38, dass sich an Position 1 befindet, auf Position 5 gefahren werden. In Schritt 9 kann das nun nachgefüllte Folienmagazin 38, dass sich auf Position 6 befindet, auf Position 1 gefahren werden. In Schritt 10 kann schließlich das andere Folienmagazin 38, dass sich nun an Position 5 befindet, bei laufendem Betrieb nachgefüllt werden. In Schritt 11 kann ein erneut leeres Folienmagazin 38, dass sich an Position 1 befindet, auf Position 6 verfahren werden. In Schritt 12 kann das nun nachgefüllte Folienmagazin 38 von Position 5 zu Position 1 gefahren werden. In einem Schritt 13 kann eine Wiederholung der Schritte 5-12 erfolgen. Die aufgezeigten Schritte 1-13 können Teil des erfindungsgemäßen Verfahrens 100 sein.

In **Fig. 12** ist eine Darstellung des Höhenausgleichssystems 50 des Folienstapels 36 und des Folienumsetzers 34 gezeigt. Dabei kann über den Toleranzbereich des Folienumsetzers 34 und den Hub des Folienstapels 36 sichergestellt werden, dass jeweils lediglich die oberste Folie 30 an der Entnahmefläche 56 des Folienstapels 36 durch den Folienumsetzer 34 aufgenommen wird. In dieser Darstellung ist das Höhenausgleichsystem 50 in Form von Vakuumsauger-Halter erkennbar. Die Vakuumsauger-Halter können beispielsweise einen Federausgleich von 10-30 mm, insbesondere 20 mm, ausgleichen.

Dies dargestellten Ausführungsformen der Anlage 10, der Folienumsetzereinheit 32 sowie des Verfahrens 100 lassen sich selbstverständlich untereinander kombinieren, sodass beispielsweise unterschiedliche Ausgestaltungen der Folienumsetzereinheit 32 mit unterschiedlichen Ausgestaltungen der Anlage 10, oder auch des Verfahrens 100, kombiniert werden können.

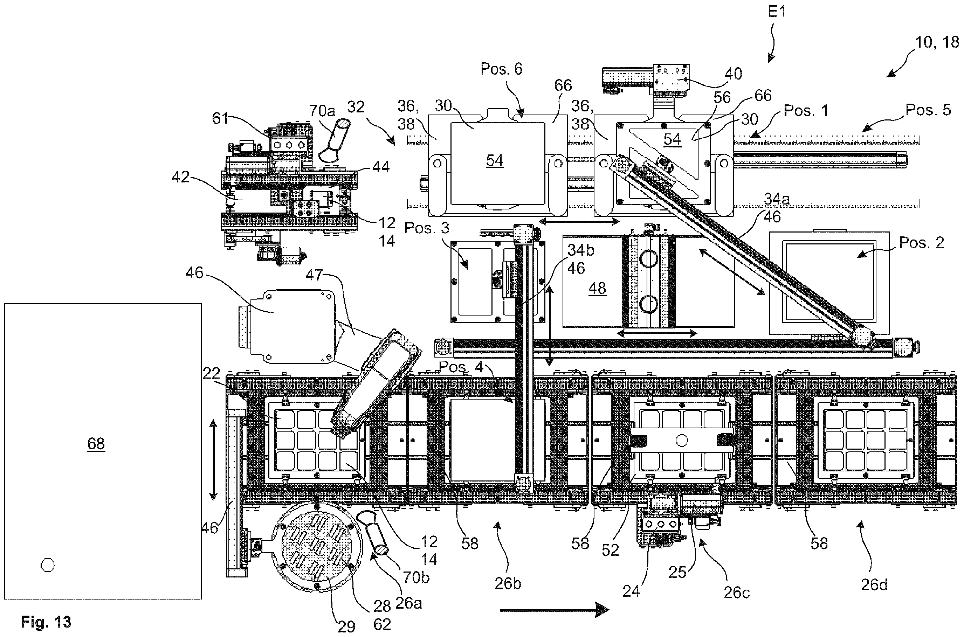

Die **Fig. 13** zeigt eine weitere Ausführungsform der in Fig. 4 dargestellten Beladestation 18, in der eine, wie in Fig. 10 dargestellte, Folienumsetzereinheit 32 integriert ist. Zur Vermeidung von Wiederholungen wird in Bezug auf die gleichen Bezugszeichen auf die Beschreibung zur Fig. 4 und zur Fig. 10 verwiesen.

In der Beladestation der Fig. 13 werden rechteckförmige Fertigungs-Werkstückträger 22 mit Kapazität für zwölf Werkstücke 14 eingesetzt, auf die eine Abdeckmaske 28 in Arbeitsposition 26a und eine Abdeckfolie 30 an der Arbeitsposition 26b aufgelegt werden kann.

Am Eingang der Beladestation 18 ist ein Stapelmagazin 68 von Fertigungs-Werkstückträger 22 angeordnet, aus der zumindest bei einer Erstbeschickung der Anlage 10 leere Fertigungs-Werkstückträger 22 entnommen werden können bzw. bei Fertigungsende eingelagert werden können. Ein Automatisierungsroboter 46 setzt Werkstücke 14 von einem Transport-Werkstückträger 44 mittels eines Greifarms 47 auf einen Fertigungs-Werkstückträger 22 um, so dass Werkstücke von zwölf Transport-Werkstückträger 44 in einem Fertigungs-Werkstückträger 22 gesammelt werden können. Insoweit kann die Anlage in einem um den Faktor Zwölf langsameren Takt als die übrige Fertigungsstraße arbeiten.

Über der Hubeinheit 61 ist eine Inspektionskamera 7a angeordnet, die eine Drehlage und X/Y-Positionierung des Werkstücks 14 auf dem Transport-Werkstückträgers 44 erfasst. Mittels dieser Information kann der Dreharm 47 des Automatisierungsroboters 46 das Werkstück 14 aufnehmen und auf dem Fertigungs-Werkstückträger 22 in exakter Drehlage und X/Y-Ausrichtung absetzen. Dazu ist über der Arbeitsposition 26a auf dem dortigen Fertigungs-Werkstückträger 22 eine weitere Inspektionskamera 26b ausgerichtet, die die exakte Absetzungslage des Automatisierungsroboters 46 steuert und eine korrekte Ausrichtung der Werkstücke 14 auf dem Fertigungs-Werkstückträger 22 gewährleistet.

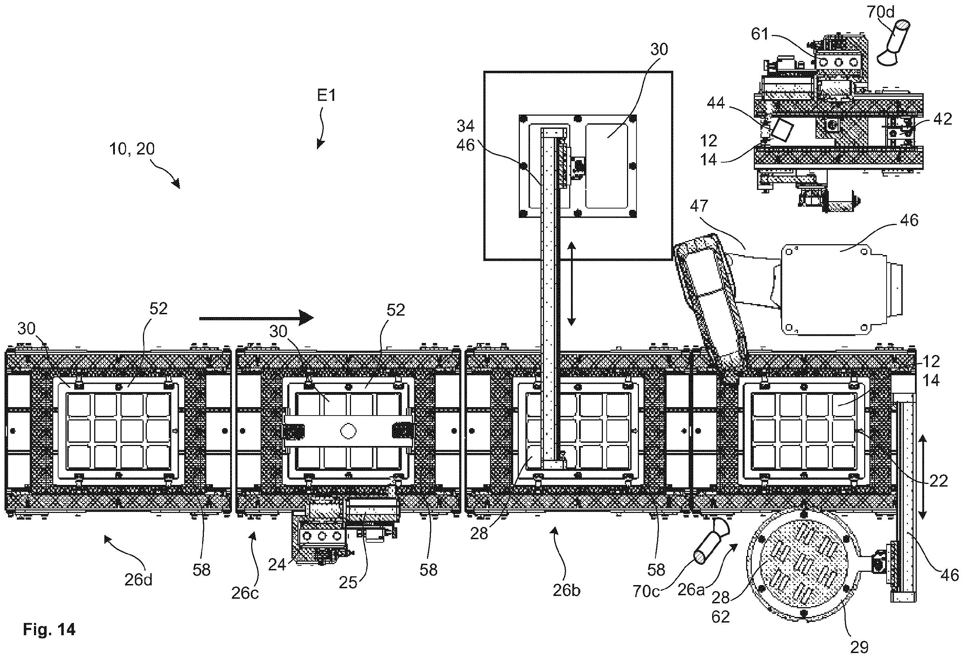

Komplementär zur Beladestation 18 der Fig. 13 stellt **Fig. 14** die zugehörige Entladestation 20 dar. Auch diese gleicht als weitere Ausführungsform 20 der in Fig. 7 beschriebenen Entladestation 20, so dass entsprechend auf die dortige Beschreibung Bezug genommen wird. Eine optische Inspektionseinrichtung umfasst mittels einer Inspektionskamera 70c über der Arbeitsposition 26a und einer weiteren Inspektionskamera 70d über der Hubeinheit 61 die Drehlage und X/Y-Ausrichtung der Werkstücke 14 auf dem Fertigungs-Werkstückträger 22 und ermöglicht eine Drehlage- und Positionsgenaues Umsetzen der Werkstücke auf einen Transport-Werkstückträger 44.

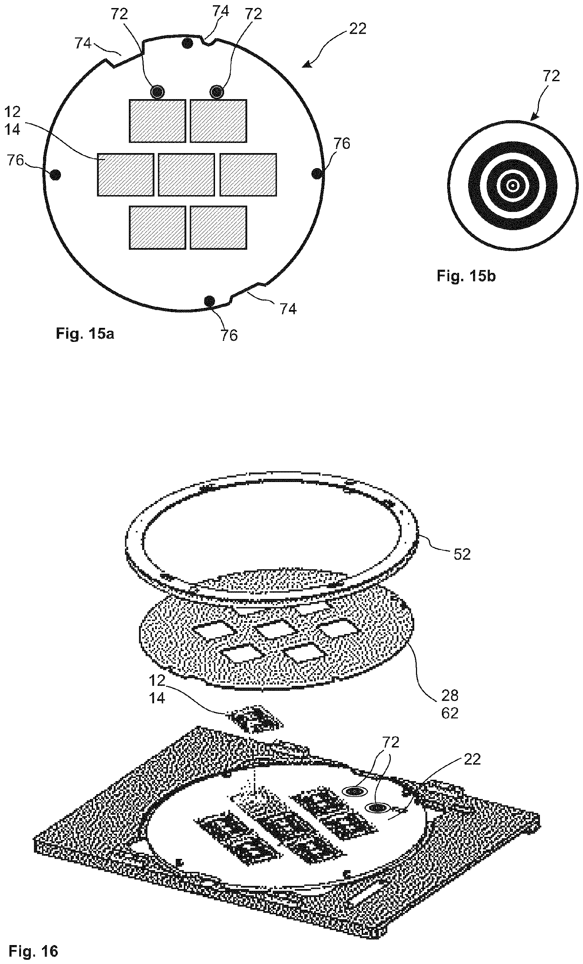

In der **Fig. 15a** ist eine Draufsicht auf eine Ausführungsform eines Einsatzes eines Fertigungs-Werkstückträger 22 mit optischen Referenzmarken 72 für eine optische Inspektionseinrichtung dargestellt. Der Einsatz des Fertigungs-Werkstückträger 22 kann in einer Matrixanordnung sieben Werkstücke 14 aufnehmen. Es sind Befestigungselemente 76, beispielsweise Ausnehmungen oder Zapfen für eine Befestigung in einem tablettartigen Rahmen des Fertigungs-Werkstückträgers 22 vorgesehen. Am äußeren Randbereich des Einsatzes sind formschlüssige Randabschnitte 74 zum formschlüssig-lagerichtigen Einsatz im Rahmen des Fertigungs-Werkstückträgers 22 vorgesehen.

Der Fertigungs-Werkstückträger 22 weist zwei optische Referenzmarken 72 auf, die mittels der optischen Inspektionseinrichtung erfasst und eine Ausrichtung des Fertigungs-Werkstückträgers auch bei einer geringen Auflösung einer Inspektionskamera 70 oder schwierigen Lichtverhältnissen ermöglichen. Im Detail ist eine optische Referenzmarke 72 in **Fig. 15b** dargestellt. Diese besteht aus einer Sequenz konzentrischer Konturen, in diesem Fall konzentrischer Ringe. Deren definierter Abstand und Breiten ermöglicht sowohl eine exakte Identifikation der X/Y-Platzierung, sowie die relative Lage zweier Referenzmarken 72 auf dem Fertigungs-Werkstückträger 22 gegeneinander eine Bestimmung der Drehlage des Fertigungs-Werkstückträgers 22.

Schließlich zeigt die **Fig. 16** perspektivisch eine Kombination eines Rahmens und des in Fig. 15a dargestellten Einsatzes des Fertigungs-Werkstückträgers 22 mit aufgenommen Werkstücken. Diese werden mit einer Prozessabdeckung 62 in Form einer Maske 28 für ein Vakuum-Sinterverfahren abgedeckt, die mittels eines Halterings 52 mit dem Fertigungs-Werkstückträgers 22 verbunden ist. Anschließend kann noch eine Folie 30 zur Abdeckung aufgelegt, und ggf. ebenfalls durch den Haltering 52 fixiert werden. Die Folie 30 verhindert beispielsweise beim Sintern ein Anheften eines elastischen Sinterkissens auf einer Oberfläche der Werkstücke.

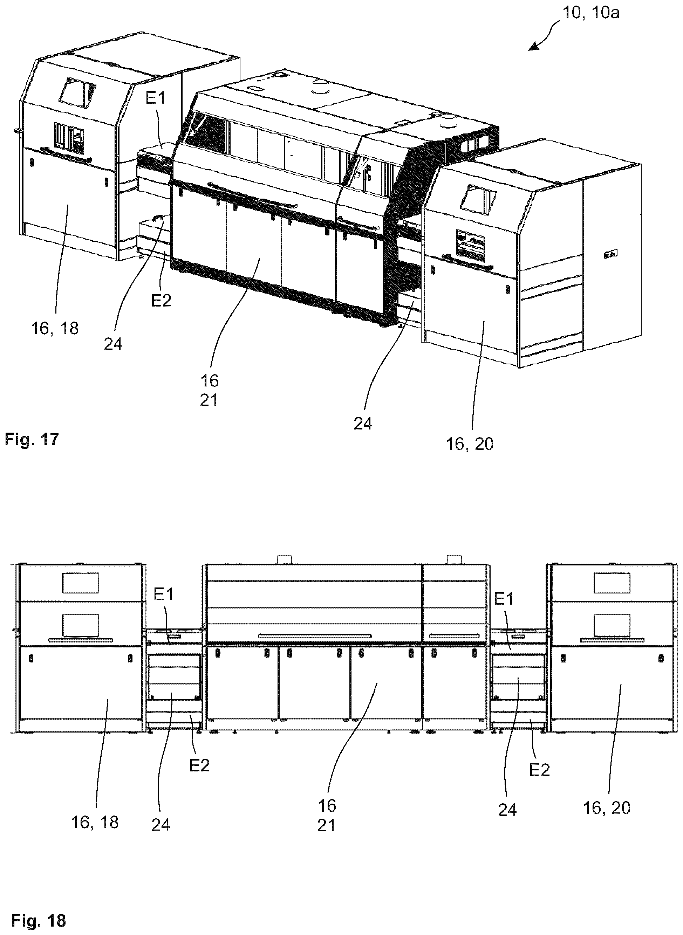

**Fig. 17** zeigt eine weitere Ausführungsform einer erfindungsgemäßen Anlage 10 zum Verbinden von elektronischen Baugruppen 12 und/oder Fertigen von Werkstücken 14 mit mehreren Modulen. Die Anlage 10 weist mehrere Module 16 auf. Eine derartige Anlage 10 kann beispielsweise eine Lötanlage 10a ausbilden. Durch eine derartige Anlage 10 können beispielsweise temperaturbeständige Lötverbindungen hergestellt werden. In dieser Ausführungsform zeigt die Anlage 10 drei Module 16. Das erste Modul 16 ist als Beladestation 18 ausgebildet. Daran schließt sich eine Fertigungsstation 21 an. Das Modul 16 am rechten Ende der Anlage 10 ist als Entladestation 20 ausgebildet. Zur Ausbildung eines Reinraums, insbesondere eines ISO 5 Reinraums, ist die Anlage bevorzugt als geschlossene Kammer und/oder gasdicht ausgebildet. Bevorzugt sind daher die Module 16 untereinander verbunden, jedoch gegenüber äußeren Einflüssen in einem gemeinsamen Gehäuse geschützt. Im Unterschied zur Ausführungsform gemäß Fig. 1 sind die Module 16 nicht direkt miteinander verbunden, sondern über mehrere Transporteinheiten 24. In den unterschiedlichen Ebenen E1, E2 sind jeweils bevorzugt als geschlossene Kammer und/oder gasdicht ausgebildete Einheiten Verbindungen ausgeformt, in welchen die Transporteinheiten 24 verlaufen. Eine der Transporteinheiten 24 kann beispielsweise eine Unterflurfördereinheit 60 ausbilden.

**Fig. 18** zeigt die Anlage aus Fig. 17 in einer Frontansicht. Dabei sind die einzelnen Verbindungsbereiche zwischen den Modulen 16, in welchen die Transporteinheit der 24 verlaufen, sichtbar. Im Gegensatz zur Ausführungsform gemäß Figs. 1 und 2 kann die Ausführungsform gemäß Figs. 17 und 18 speziell als Lötanlage ausgebildet sein. Der Unterschied zu einer Anlage gemäß den Figs. 1 und 2 liegt darin, dass in einer Lötanlage auf die Arbeitsposition verzichtet werden kann, welche zur Auflegung von Folien als Folienumsetzereinheit 32 ausgebildet ist. In den weiteren Ausführungen kann die Ausführungsform gemäß Figs. 17 und 18 mit der gemäß Figs. 1 und 2 übereinstimmen.

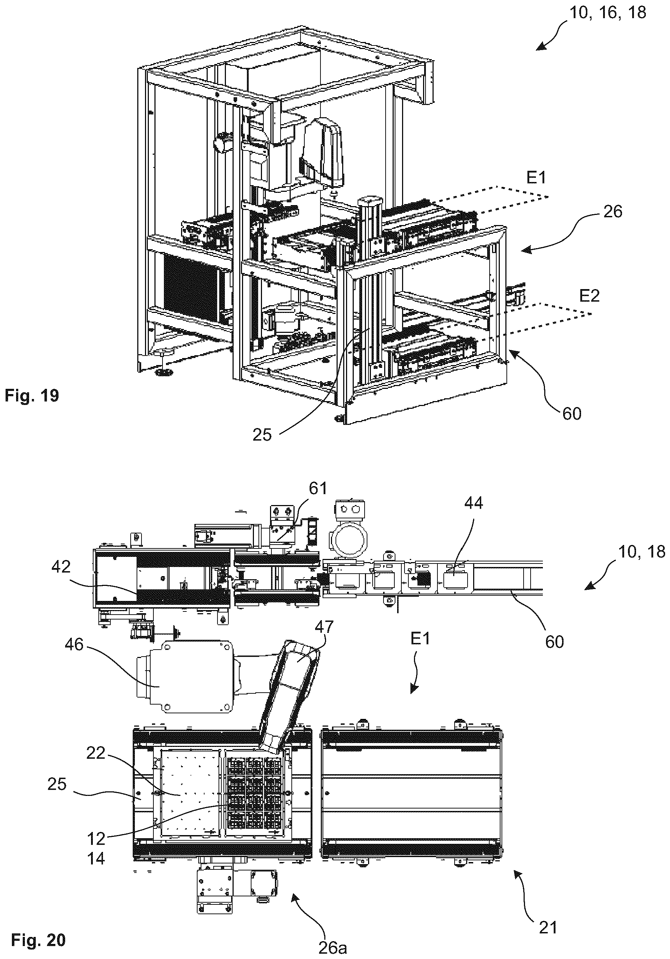

**Fig. 19** zeigt eine weitere Ausführungsform eines Moduls 16 einer erfindungsgemäßen Anlage 10, das als Beladestation 18 ausgebildet ist. Die Beladestation 18 ist ohne Gehäuse dargestellt, wodurch das Innere sichtbar ist. In dieser Darstellung ist eine Hubeinheit 25 der Transporteinheit 24 in Ebene E1 erkennbar. Diese ist mit der Unterflurfördereinheit 60 verbunden, die unterhalb der Ebene E1 auf der Ebene E2 angeordnet ist. Um die Fertigungs-Werkstückträger 22 von der unteren Ebene E2, in der die Unterflurfördereinheit 60 angeordnet ist, in die obere Ebene E1, in der die Arbeitspositionen 26 angeordnet sind, zu befördern, kann die Hubeinheit 25 eingesetzt werden. Die Hubeinheit 25 kann durch einen Hub von Ebene E1 in Ebene E2, oder andersherum, die Fertigungs-Werkstückträger 22 befördern. Dieser Vorgang wurde bereits ausführlich bezüglich Fig. 3 beschrieben. Im Unterschied zur Ausführungsform gemäß Fig. 3 zeigt die Ausführungsform gemäß Fig. 19 eine Beladestation 18 für eine Lötanlage nach Figs. 17 und 18. In einer derartigen Ausführungsform kann auf die Folienumsetzereinheit verzichtet werden.

**Fig. 20** zeigt das Modul 16 aus Fig. 19 in einer Draufsicht mit der Darstellung unterschiedlicher Arbeitspositionen. In der Arbeitsposition 26a erfolgt ein Auflegen der elektronischen Baugruppen 12 und/oder Werkstücke 14 auf einen Fertigungs-Werkstückträger 22. Dies kann auch als Vorkonfektionierung bezüglich des Verfahrens 100 bezeichnet werden. Die elektronischen Baugruppen 12 und/oder Werkstücken14 können mit einem Automatisierungsroboter 46, insbesondere einem Roboterarm 47, auf den Fertigungs-Werkstückträger 22 umgesetzt werden. Die kann auch durch Deckenmontage erfolgen. Im Gegensatz zur Ausführungsform gemäß Figs. 4 zeigt die Ausführungsform gemäß Fig. 20 keine Arbeitsposition 26b zum Auflegen einer Folie. Die Ausführungsform gemäß Fig. 20 zeigt dadurch insbesondere eine Lötanlage. Nach der Arbeitsposition 26a kann eine weitere Fertigungsstation 21 angeordnet sein, beispielsweise in Form eines Transportbandes, das als Puffer bzw. Pufferstation dient. Im oberen Bildbereich ist eine zweite Transporteinheit 42 angeordnet, die eine Hubeinheit 61 aufweist. An dieser zweiten Transporteinheit 42 ist eine Unterflurfördereinheit 60 angeordnet, auf welcher die Transport-Werkstückträger 44 angeordnet sind. In den weiteren Ausführungsformen kann die Darstellung Merkmale wie die Ausführungsform gemäß Figs. 4 aufweisen, mit Ausnahme der Folienumsetzereinheit 32.

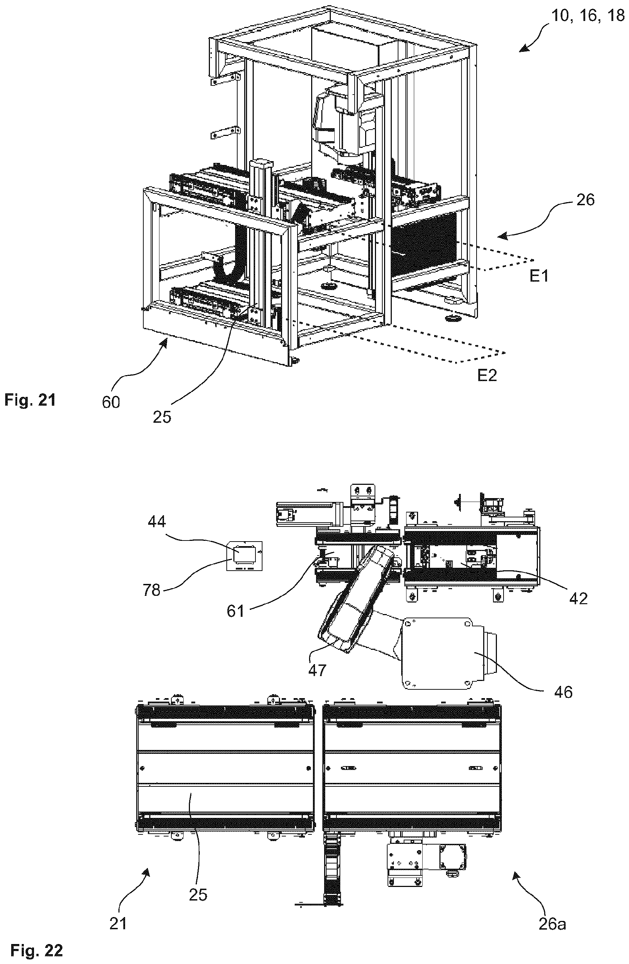

**Fig. 21** zeigt eine weitere Ausführungsform eines Moduls 16 einer erfindungsgemäßen Anlage 10, das als Entladestation 20 ausgebildet ist. Die Entladestation 20 ist ohne Gehäuse dargestellt, wodurch das Innere sichtbar ist. In dieser Darstellung ist eine Hubeinheit 25 der Transporteinheit 24 in Ebene E1 erkennbar. Diese ist mit der Unterflurfördereinheit 60 verbunden, die unterhalb der Ebene E1 auf der Ebene E2 angeordnet ist.

**Fig. 22** zeigt das Modul 16 aus Fig. 21 in einer Draufsicht mit der Darstellung der Arbeitsposition 26a. Vor der Arbeitsposition 26 ist eine weitere Fertigungsstation 21 angeordnet, die beispielsweise als Kühlstation ausgebildet sein kann. Mit dem Roboterarm 47 können die Werkstücke 14 von der Arbeitsposition 26a auf die zweite Transporteinheit 42 transportiert werden. Die zweite Transporteinheit 42 umfasst eine Hubeinheit 61 zum Transport der Transport-Werkstückträger 44. Des Weiteren ist ein Magazin 78 umfasst, dass die leeren Transport-Werkstückträger 44 aufnehmen kann.

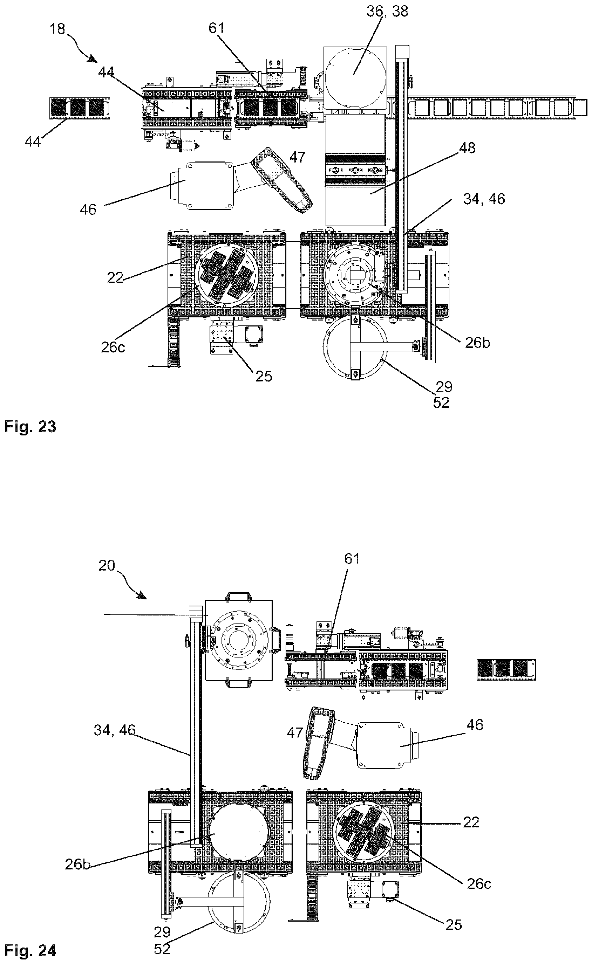

Die **Figs. 23** und **24** zeigen zwei weitere Ausführungsformen einer Beladestation 18 und einer Entladestation 20 als Anbaumodul 16 einer Anlage 10. Grundsätzlich entsprechen diese in Ihrem funktionellen Ablauf und strukturellem Aufbau den in den Figs. 13 und 14 im Detail erläuternden Be- und Endladestationen 18, 20.

Eine mögliche Arbeitsreihenfolge der Beladestation 18 der Fig. 23 sieht bei Verwendung einer einzelnen Oberfolie 30 für eine Sinterverbindung wie folgt aus:
- Zunächst kann ein Fertigungs-Werkstückträger 22 mit einer Hubeinheit 25 von einer Unterflurfördereinheit 60 auf eine Arbeitsebene in Position 26c angehoben werden;
- Hiernach werden durch den Roboterarm 47 des Automatisierungsroboters 46 eine Mehrzahl von Werkstücken 14, z.B. 10 bis 14, insbesondere 12 DCB-PCBs (Direct Bonded Copper Printed Circuit Boards) aus einem Transport-Warenträger 44 in den Fertigungs-Werkstückträger 22 umgesetzt;
- Hiernach wird der bestückte Fertigungs-Werkstückträger 22 von Position 26c in Position 26b verfahren;
- Anschließend kann der Haltering 52, der bisher auf dem Fertigungs-Werkstückträger 22 gelagert war, in eine Parkposition 29 versetzt werden;
- Eine Folie 30, z.B. eine PTFE-Folie für Sinterbearbeitung, wird als Oberfolie aus dem Folienstapel 35 aus der Folienumsetzereinheit 32 entnommen, durch die Folien-Reinigungseinheit 48 gereinigt und anschließend auf den bestückten Fertigungs-Werkstückträger 22 aufgebracht;
- Hiernach wird der Haltering 52 aus der Parkposition 29 zur Fixierung der Folie 30 auf dem Fertigungs-Werkstückträger 22 aufgesetzt und befestigt;
- Anschließend wird der Werkstückträger 22 in ein Vorheizmodul zur Vorbereitung auf das Sinterverfahren verfahren.

Alternativ kann bei Verwendung einer Unterfolie 30 und einer Oberfolie 30 nach Anheben des Fertigungs-Werkstückträger 22 aus der Unterflurfördereinheit 60 bereits in Position 26b nach Verbringen des Halterings 29 in die Parkposition 52 die Unterfolie 30 zunächst auf den Fertigungs-Werkstückträger 22 gelegt werden, wonach in Position 26c die Bestückung der Werkstücke 14 erfolgt.

In spiegelbildlicher Weise kann die Entladestation 20 der Fig. 24, die sich im Sinne der Fließfertigung sequentiell hinter dem Sintermodul 21 befindet, arbeiten, und folgende Arbeitsschritte bei Verwendung einer Oberfolie 30für eine Sinterverbindung ausführen:
- Einfahren eines Fertigungs-Werkstückträgers 22 von einer Fertigungsstation 21, beispielsweise einem Kühlmodul 16 in die Entladestation 20;
- Anheben des Halterings 52 und Verbringen in eine Parkposition 29 in einer Position 26b des Entlademoduls 20;
- Greifen und Abziehen der Folie 30 vom bestückten Fertigungs-Werkstückträger 22 mittels eines Folienumsetzers 34;
- Zurücklegen des Halterings 52 aus der Parkposition 29 auf den Fertigungs-Werkstückträger 22;
- Verschieben des Fertigungs-Werkstückträgers 22 von der Position 26b in die Position 26c;
- Umsetzen der Werkstücke 14 mittels des Roboterarms 47 vom Fertigungs-Werkstückträger 22 auf einen Transport-Werkstückträger 44, wobei jeder Umsetzvorgang weniger als 6 Sekunden, insbesondere 5,5 Sekunden benötigt;
- Verfahren des Fertigungs-Werkstückträger 22 durch die Hubeinheit 25 auf die Unterflurfördereinheit 60 zum Rücktransport zur Beladestation 18.

Bei Verwendung einer Unterfolie 30 und einer Oberfolie 30 kann nach Verschieben des Fertigungs-Werkstückträgers 22 von der Position 26b in die Position 26c die Unterfolie 30 durch einen Automatisierungsroboter 46 anschließend abgezogen werden.

Beim Rücktransport aus der Beladestation 20 in die Entladestation 18 können gebrauchte Folien auf den Fertigungs-Werkstückträger 22 aufgelegt, zurücktransportiert und wieder auf den Folienstapel 36 gesetzt werden, oder auf einen weiteren Folienstapel innerhalb der Entladestation 20 gesetzt werden, der händisch wieder in die Beladestation 18 zur Wiederverwendung verbracht werden kann.

Die oder eine zweite Reinigungseinheit 48 kann nach Entnahme der gebrauchten Folie 30 in der Entladestation 20 eine Reinigung der Folie 30 bereits in der Entladestation 20 vornehmen,

### Bezugszeichenliste

- 10: Anlage
- 10a: Sinter- oder Lötanlage
- 12: elektronische Baugruppe
- 14: Werkstück
- 16: Modul
- 18: Beladestation
- 20: Entladestation
- 21: Fertigungsstation
- 22: Fertigungs-Werkstückträger
- 24: Transporteinheit
- 25: Hubeinheit
- 26: Arbeitsposition
- 26a-26d: Arbeitsposition
- 28: Maske
- 29: Parkposition
- 30: Folie
- 32: Folienumsetzereinheit
- 34: Folienumsetzer
- 34a, 34b: Folienumsetzer
- 36: Folienstapel
- 38: Folienmagazin
- 40: Folien-Hebeeinheit
- 42: zweite Transporteinheit
- 44: Transport-Werkstückträger
- 46: Automatisierungsroboter
- 47: Roboterarm
- 48: Reinigungseinheit
- 50: Höhenausgleichssystem
- 52: Haltering
- 54: Oberseite
- 56: Entnahmefläche
- 58: Verfahreinheit
- 60: Unterflurfördereinheit
- 61: Hubeinheit
- 62: Prozessabdeckung
- 64: Lineareinheit
- 66: Folienträger
- 68: Stapelmagazin von Fertigungs-Werkstückträger
- 70: Inspektionskamera
- 72: Optische Referenzmarke
- 74: Formschlüssiger Randabschnitt
- 76: Befestigungselement
- 78: Magazin

- 100: Verfahren
- E1: obere Ebene
- E2: untere Ebene

## Patentansprüche

1. Anlage (10) zum Verbinden von elektronischen Baugruppen (12) und/oder zum Fertigen von Werkstücken (14), insbesondere eine Sinter- oder Lötanlage (10a), umfassend mehrere Module (16) zum Verbinden der elektronischen Baugruppen (12) und/oder zum Fertigen der Werkstücke (14), wobei zumindest ein Modul (16) als Beladestation (18) und ein Modul (16) als Entladestation (20) ausgebildet ist, oder ein Modul als Beladestation (18) und als Entladestation (20) ausgebildet ist, wobei zumindest ein weiteres Modul (16) als Fertigungsstation (21) ausgebildet ist, und ein Fertigungs-Werkstückträger (22) zur Aufnahme der elektronischen Baugruppen (12) und/oder der Werkstücke (14) vorgesehen ist, der über eine Transporteinheit (24) von der Beladestation (18) über die Fertigungsstation (21) zur Entladestation (20) automatisiert bewegbar ist, wobei die Anlage (10) insbesondere für eine Fließfertigung ausgebildet ist,
**dadurch gekennzeichnet, dass** eine Folienumsetzereinheit (32) umfasst ist, mit zumindest einem, insbesondere zwei oder mehreren Folienumsetzern (34), die zum automatisierten Aufbringen von Folien (30) als eine Prozessabdeckung (62) in der Beladestation (18) ausgebildet ist.

2. Anlage (10) nach Anspruch 1, **dadurch gekennzeichnet, dass** die Fertigungsstation (21) zumindest ein weiteres Modul (16) als Lötmodul und/oder als Sintermodul, bevorzugt mehr als ein weiteres Modul (16), insbesondere ein Vorheizmodul, ein Plasmamodul, ein Lötmodul, ein Sintermodul und/oder ein Kühlmodul umfasst, und/oder dass ein Modul (16) als Beladestation (18) und ein Modul (16) als Entladestation (20) ausgebildet ist, wobei die Beladestation (18) der Fertigungsstation (21) vorgeschaltet ist und die Entladestation (20) der Fertigungsstation (21) nachgeschaltet ist, und eine Transporteinheit (24) die elektronischen Baugruppen (12) und/oder Werkstücke (14) von der Entladestation (20), insbesondere unter Umgehung der Fertigungsstation (21), zurück zur Beladestation (18) transportiert.

3. Anlage (10) nach einem der vorhergehenden Ansprüche, **dadurch gekennzeichnet, dass** in der Beladestation (18) und/oder Entladestation (20) zumindest ein Automatisierungsroboter (46) vorgesehen ist, durch den die elektronischen Baugruppen (12) und/oder die Werkstücke (14) von einem Transport-Werkstückträger (44) auf den Fertigungs-Werkstückträger (22) in der Beladestation (18) automatisiert auflegbar sind, wobei insbesondere eine weitere Transporteinheit (42) zur Aufnahme des Transport-Werkstückträgers (44) vorgesehen ist, die unabhängig von den Modulen (16) von der Beladestation (18) zu der Entladestation (20), insbesondere unter Umgehung der Fertigungsstation (21), verfahrbar ist.

4. Anlage (10) nach einem der vorhergehenden Ansprüche, **dadurch gekennzeichnet, dass** die Beladestation (18) eingerichtet ist, eine Prozessabdeckung (62) auf die elektronischen Baugruppen (12) und/oder die Werkstücke (14) aufzubringen, und/oder die Entladestation (20) eingerichtet ist, die Prozessabdeckung (62) von den elektronischen Baugruppen (12) und/oder den Werkstücken (14) zu entfernen, insbesondere mittels eines Automatisierungsroboters (46) aufzubringen und/oder zu entfernen.

5. Anlage (10) nach einem der vorhergehenden Ansprüche, **dadurch gekennzeichnet, dass** die Beladestation (18) und/oder die Entladestation (20) zumindest zwei Arbeitspositionen (26), insbesondere drei oder vier Arbeitspositionen (26), umfasst, wobei der Fertigungs-Werkstückträger (22) von einer Arbeitsposition (26) zu einer benachbarten Arbeitsposition (26) automatisiert, insbesondere über eine Verfahreinheit (58), verfahrbar ist.

6. Anlage (10) nach Anspruch 4 oder 5, **dadurch gekennzeichnet, dass** die Beladestation (18) drei Arbeitspositionen (26) umfasst, die über eine Verfahreinheit (58) miteinander verbunden sind, wobei auf einer ersten Arbeitsposition (26) die elektronischen Baugruppen (12) und/oder die Werkstücke (14) durch einen Automatisierungsroboter (46) automatisiert auflegbar sind und eine Maske (28) als erste Prozessabdeckung (62) auf die elektronischen Baugruppen (12) und/oder auf die Werkstücke (14) über einen Automatisierungsroboter (46) automatisiert auflegbar ist, in einer zweiten Arbeitsposition (26) eine Folie (30) als zweite Prozessabdeckung (62) auf die Maske (28) über einen Automatisierungsroboter (46) automatisiert auflegbar ist, und in einer dritten Arbeitsposition (26) ein Verschließen des Fertigungs-Werkstückträgers (22) mit der Folie (30), insbesondere über einen Haltering (52) mittels eines Automatisierungsroboters (46), automatisiert erfolgt.

7. Anlage (10) nach einem der Ansprüche 2 bis 6, **dadurch gekennzeichnet, dass** die Beladestation (18) und die Entladestation (20) gespiegelt zueinander ausgebildet sind.

8. Anlage (10) nach einem der vorhergehenden Ansprüche, **dadurch gekennzeichnet, dass** die Transporteinheit (24) zum Transport des Fertigungs-Werkstückträgers (22) eine Hubeinheit (25) und eine Unterflurfördereinheit (60) umfasst, wobei der Verfahrweg der Unterflurfördereinheit (60) innerhalb der Anlage (10), und insbesondere unter Umgehung der Fertigungsstation (21), angeordnet ist, und insbesondere unterhalb einer Ebene verläuft, in der ein Beladen und/oder Entladen des Fertigungs-Werkstückträgers (22) erfolgt, und/oder dass eine optische Inspektionseinheit umfassend zumindest eine Inspektionskamera (70a, 70b, 70c, 70d) in der Beladestation (18) und/oder in der Entladestation (20) vorgesehen ist, die eine lagerichtige Ausrichtung der Baugruppen (12) und/oder der Werkstücke (14) in dem Fertigungs-Werkstückträger (22) erfassen und protokollieren kann.

9. Anlage (10) nach einem der vorhergehenden Ansprüche, **dadurch gekennzeichnet, dass** die Folienumsetzereinheit (32) zumindest ein, insbesondere zwei, Folienstapel (36) umfasst, die als Folienmagazin (38) ausgebildet sind und an einer Oberseite (54) eine Entnahmefläche (56) für eine obere Folie (30) aufweist, wobei insbesondere der Folienstapel (36) über eine Folien-Hebeeinheit (40) verfügt, die ein schrittweises Anheben des Folienstapels (36) in Richtung der Oberseite (54) ermöglicht.

10. Folienumsetzereinheit (32) und Anlage (10) nach einem der vorhergehenden Ansprüche, **dadurch gekennzeichnet, dass** zumindest ein, insbesondere zwei, Folienumsetzer (34) und zumindest ein, insbesondere zwei, Folienstapel (36) umfasst sind, wobei insbesondere eine Reinigungseinheit (48) für eine Reinigung einer obersten und/oder einer untersten Folie (30) vor dem Umsetzen auf die elektronischen Baugruppen (12) und/oder auf die Werkstücke (14) umfasst ist, wobei bevorzugt die Reinigungseinheit (48) eine Linearreinigungseinheit umfasst oder als berührungslos arbeitendes Oberflächenreinigungssystem ausgebildet ist.

11. Folienumsetzereinheit (32) und Anlage nach einem der Ansprüche 8 bis 10, **dadurch gekennzeichnet, dass** der Folienstapel (36) als Folienmagazin (38) mit einer Folien-Hebeeinheit (40) ausgebildet ist, sodass eine jeweils oberste Folie (30) des Folienstapels (36) um einen Hub nach oben in Richtung der Oberseite (54) verfahrbar ist, und der Folienumsetzer (34) ein Höhenausgleichssystem (50) aufweist.

12. Folienumsetzereinheit (32) und Anlage nach einem der Ansprüche 10 oder 11, **dadurch gekennzeichnet, dass** ein erster Folienumsetzer (34a) zum Entnehmen einer obersten Folie (30) von dem Folienstapel (36) und Einlegen in die Reinigungseinheit (48) ausgebildet ist, ein zweiter Folienumsetzer (34b) zum Entnehmen der Folie (30) aus der Reinigungseinheit (48) und Auflegen auf den Fertigungs-Werkstückträger (22) mit den elektronischen Baugruppen (12) und/oder den Werkstücken (14) ausgebildet ist.

13. Verfahren (100) zum Verbinden von elektronischen Baugruppen (12) und/oder zum Fertigen von Werkstücken (14), insbesondere zur Fließfertigung und bevorzugt unter Verwendung einer Anlage nach einem der vorgenannten Ansprüche 1 bis 13, **gekennzeichnet durch folgende Schritte:**
- Vorkonfektionierung von elektronischen Baugruppen (12) und/oder Werkstücken (14) auf einem Fertigungs-Werkstückträger (22) in der Beladestation (18) zur Bearbeitung in einer Fertigungsstation (21), insbesondere umfassend einer Vorheizmodul, ein Löt- oder Sintermodul und/oder ein Kühlmodul, wobei zumindest ein automatisches Aufbringen zumindest einer Folie (30), als Prozessabdeckung (62) auf die elektronischen Baugruppen (12) und/oder die Werkstücke (14) erfolgt;
- Automatisiertes Verfahren des Fertigungs-Werkstückträgers (22) von der Beladestation (18) zu zumindest der Fertigungsstation (21);
- Automatisiertes Rückführen des Fertigungs-Werkstückträgers (22) zu der Beladestation (18), insbesondere unter Umgehung der Fertigungsstation (21).

14. Verfahren (100) nach Anspruch 13, **wobei** in der Vorkonfektionierung in der Beladestation (18) ein automatisiertes Umsetzen der elektronischen Baugruppen (12) und/oder der Werkstücke (14) von einem Transport-Werkstückträger (44) auf den Fertigungs-Werkstückträger (22) erfolgt, **wobei** insbesondere in einer Entladestation (20) nach Durchlauf der elektronischen Baugruppen (12) und/oder der Werkstücke (14) durch die Fertigungsstation (21), insbesondere vor einem automatisierten Rückführen des Fertigungs-Werkstückträgers (22) von der Beladestation (18) zur Entladestation (20), ein Entladen der elektronischen Baugruppen (12) und/oder der Werkstücke (14) von dem Fertigungs-Werkstückträger (22) in den Transport-Werkstückträger (44) erfolgt.

15. Verfahren (100) nach einem der Ansprüche 13 oder 14, **dadurch gekennzeichnet, dass** in der Beladestation (18)
- in einer ersten Arbeitsposition (26) auf die elektronischen Baugruppen (12) und/oder die Werkstücke (14), die auf dem Fertigungs-Werkstückträger (22) angeordnet sind, eine Maske (28) als erste Prozessabdeckung (62) automatisiert aufgelegt wird;
- in einer zweiten Arbeitsposition (26) zumindest eine Folie (30), insbesondere eine temperaturbeständige Ausgleichsfolie, auf die Maske (28) als zweite Prozessabdeckung (62) automatisiert aufgelegt wird;
- und insbesondere in einer dritten Arbeitsposition (26) ein Fixieren der Folie (30) mit der Maske (28) und dem Fertigungs-Werkstückträger (22) automatisiert, bevorzugt mit einem Haltering (52), erfolgt.

16. Verfahren (100) nach einem der Ansprüche 13 bis 15, **dadurch gekennzeichnet, dass** in der Entladestation (20) die Arbeitspositionen (26) in umgekehrter Reihenfolge angeordnet sind und in umgekehrter Reihenfolge durchgeführt werden wobei insbesondere das Rückführen des Fertigungs-Werkstückträgers (22) in einer Ebene erfolgt, die unterhalb, oberhalb oder benachbart in einer Ebene angeordnet ist, in der der Fertigungs-Werkstückträger (22) beim Beladen und/oder Entladen angeordnet ist, und wobei insbesondere das Rückführen des Fertigungs-Werkstückträgers (22) durch eine erste Transporteinheit (24) erfolgt, und der Transport-Werkstückträger (44) auf einer weiteren Transporteinheit (42) angeordnet ist, die insbesondere automatisiert verfährt, wobei die erste Transporteinheit (24) und die weitere Transporteinheit (42) unabhängig voneinander, und insbesondere unter Umgehung der Fertigungsstation (21), verfahrbar sind.

17. Verfahren (100) nach einem der Ansprüche 13 bis 16, **dadurch gekennzeichnet, dass** der Transport-Werkstückträger (44) eine elektronische Baugruppe (12) und/oder ein Werkstück (14), und der Fertigungs-Werkstückträger (22) mehr als zwei, bevorzugt mehr als fünf, insbesondere mehr als sieben, und im Speziellen vierundzwanzig oder mehr elektronische Baugruppen (12) und/oder Werkstücke (14) aufnimmt, sodass beim Beladen und/oder Entladen der Fertigungs-Werkstückträger (22) an einer Position in der Beladestation (18) verweilt, bis die Transporteinheit (42) den Fertigungs-Werkstückträger (22) mit elektronischen Baugruppen (12) und/oder Werkstücken (14) voll beladen hat.

18. Verfahren (100) nach einem der Ansprüche 13 bis 17, **dadurch gekennzeichnet, dass** in der Beladestation (18) ein Auflegen einer Folie (30) als Prozessabdeckung (62) auf den Fertigungs-Werkstückträger (22) mit den elektronischen Baugruppen (12) und/oder den Werkstücken (14) erfolgt, wobei die Folie (30) entweder eine neue Folie (30) oder eine in einem vorherigen Durchgang des Verfahrens (100) bereits verwendete Folie (30) ist.

19. Verfahren (100) nach Anspruch 18, **dadurch gekennzeichnet, dass** die Folie (30) mit einem Folienumsetzer (34) von einem Folienstapel (36) entnommen und auf die elektronischen Baugruppen (12) und/oder die Werkstücke (14) aufgelegt wird, wobei der Folienstapel (36) schrittweise in Richtung einer Oberseite (54) des Folienstapels (36) nach oben verfahren wird, sodass die jeweils oberste Folie (30) mit dem Folienumsetzer (34) erreichbar ist, und wobei bevorzugt eine Prüfung der Folienentnahme vorgenommen wird, wobei bevorzugt der Folienstapel (36) nach einer gewissen Anzahl an entnommenen Folien (30) um einen Hub von 5 mm bis 15 mm, insbesondere 10 mm, nach oben verfahren wird, wobei insbesondere nach 5 bis 10 entnommenen Folien (30) der Folienstapel (36) nach oben verfahren wird.

20. Verfahren (100) nach Anspruch 19, **dadurch gekennzeichnet, dass** vor dem Auflegen der Folie (30) auf den Fertigungs-Werkstückträger (22) mit den elektronischen Baugruppen (12) und/oder den Werkstücken (14) ein automatisiertes Reinigen der Folie (30) mittels einer Reinigungseinheit (48) erfolgt, wobei bevorzugt in der Reinigungseinheit (48) die Folie (30) elektrostatisch entladen wird und anschließend Verunreinigungen durch Abblasen mit Druckluft und / oder Unterdruck entfernt werden.

21. Verfahren (100) nach einem der Ansprüche 19 oder 20, **dadurch gekennzeichnet, dass** zumindest zwei Folienstapel (36) nebeneinander angeordnet sind, wobei ein zweiter Folienstapel (36) an eine Position eines ersten Folienstapels (36) verfahren wird, sobald der erste Folienstapel (36) keine Folien (30) mehr enthält, sodass ein kontinuierliches Verfahren gewährleistet wird.

22. Verfahren nach einem der Ansprüche 12 bis 21, **dadurch gekennzeichnet, dass** eine lagerichtige Ausrichtung der Baugruppen (12) und/oder der Werkstücke (14) zumindest in dem Fertigungs-Werkstückträger (22) optisch erfasst und protokolliert wird.

## Claims

1. An installation (10) for connecting electronic assemblies (12) and/or for manufacturing workpieces (14), in particular a sintering or soldering installation (10a), comprising a plurality of modules (16) for connecting the electronic assemblies (12) and/or for manufacturing the workpieces (14), wherein at least one module (16) is configured as a loading station (18) and one module (16) as an unloading station (20), or one module is configured as a loading station (18) and unloading station (20), wherein at least one further module (16) is configured as a manufacturing station (21), and a manufacturing workpiece carrier (22) is provided for accommodating the electronic assemblies (12) and/or the workpieces (14), which is movable in automated manner by way of a conveying unit (24) from the loading station (18) via the manufacturing station (21) to the unloading station (20), wherein the installation (10) is configured in particular for assembly line production,
**characterized in that** a foil/film transfer unit (32) is included with at least one, in particular two or more foil/film transfer means (34), which are configured for automated application of foils/films (30) as a process cover (62) in the loading station (18).

2. The installation (10) according to claim 1, **characterized in that** the manufacturing station (21) comprises at least one further module (16) as a soldering module and/or as a sintering module, preferably more than one further module (16), in particular a preheating module, a plasma module, a soldering module, a sintering module and/or a cooling module, and/or that one module (16) is configured as a loading station (18) and one module (16) as an unloading station (20), wherein the loading station (18) is arranged upstream of the manufacturing station (21) and the unloading station (20) is arranged downstream of the manufacturing station (21), and a conveying unit (24) conveys the electronic assemblies (12) and/or workpieces (14) from the unloading station (20), in particular bypassing the manufacturing station (21), back to the loading station (18).

3. The installation (10) according to any of the preceding claims, **characterized in that** at least one automation robot (46) is provided in the loading station (18) and/or unloading station (20), by which robot the electronic assemblies (12) and/or the workpieces (14) are transferrable in automated manner from a conveying workpiece carrier (44) onto the manufacturing workpiece carrier (22) in the loading station (18), wherein in particular a further conveying unit (42) is provided for accommodating the conveying workpiece carrier (44) and is movable, independently of the modules (16), from the loading station (18) to the unloading station (20), in particular bypassing the manufacturing station (21).

4. The installation (10) according to any of the preceding claims, **characterized in that** the loading station (18) is configured to attach a process cover (62) onto the electronic assemblies (12) and/or workpieces (14), and/or the unloading station (20) is configured to remove the process cover (62) from the electronic assemblies (12) and/or workpieces (14), to attach and/or remove it in particular by means of an automation robot (46).

5. The installation (10) according to any of the preceding claims, **characterized in that** the loading station (18) and/or the unloading station (20) comprises at least two working positions (26), in particular three or four working positions (26), wherein the manufacturing workpiece carrier (22) is movable in automated manner, in particular by a displacement unit (58), from one working position (26) to an adjacent working position (26).

6. The installation (10) according to claim 4 or 5, **characterized in that** the loading station (18) comprises three working positions (26), which are connected together by way of a displacement unit (58), wherein on a first working position (26) the electronic assemblies (12) and/or the workpieces (14) are placeable in automated manner by an automation robot (46) and a mask (28) is placeable in automated manner, as a first process cover (62), onto the electronic assemblies (12) and/or the workpieces (14) by way of an automation robot (46), and in a second working position (26) a foil/film (30) may be placed in automated manner, as a second process cover (62), onto the mask (28) by way of an automation robot (46), and in a third working position (26) closure of the manufacturing workpiece carrier (22) with the foil/film (30) proceeds in automated manner, in particular by way of a retaining ring (52) by means of an automation robot (46).

7. The installation (10) according to any of claims 2 to 6, **characterized in that** the loading station (18) and the unloading station (20) are mirror images of one another.

8. The installation (10) according to any of the preceding claims, **characterized in that** the conveying unit (24) for conveying the manufacturing workpiece carrier (22) comprises a lifting unit (25) and an underfloor conveying unit (60), wherein the movement path of the underfloor conveying unit (60) is arranged inside the system (10), in particular bypassing the manufacturing station (21), and in particular underneath a level in which loading and/or unloading of the manufacturing workpiece carrier (22) take place, and/or that an optical inspection unit comprising at least one inspection camera (70a, 70b, 70c, 70d) is provided in the loading station (18) and/or in the unloading station (20), and can detect and log a positionally correct alignment of the assemblies (12) and/or workpieces (14) in the manufacturing workpiece carrier (22).

9. The installation (10) according to any of the preceding claims, **characterized in that** the foil/film transfer unit (32) comprises at least one, in particular two, foil/film stacks (36), which are configured as a foil/film magazine (38) and have a withdrawal surface (56) for a top foil/film (30) at the top (54), wherein in particular the foil/film stack (36) has a foil/film lifting unit (40) which enables gradual raising of the foil/film stack (36) towards the top (54).

10. A foil/film transfer unit (32) and installation (10) according to any of the preceding claims, **characterized in that** at least one, in particular two foil/film transfer means (34) and at least one, in particular two, foil/film stacks (36) are comprised, wherein in particular a cleaning unit (48) is comprised for cleaning a top and/or a bottom foil/film (30) before transfer onto the electronic assemblies (12) and/or workpieces (14), wherein the cleaning unit (48) preferably comprises a linear cleaning unit or is configured as a contactlessly operating surface cleaning system.

11. The foil/film transfer unit (32) and installation according to any of claims 8 to 10, **characterized in that** the foil/film stack (36) is configured as a foil/film magazine (38) with a foil/film lifting unit (40), such that a respectively top foil/film (30) of the foil/film stack (36) is movable towards the top (54) by a certain upward travel, and the foil/film transfer means (34) has a height-equalizing system (50).

12. The foil/film transfer unit (32) and installation according to one of claims 10 or 11, **characterized in that** a first foil/film transfer means (34a) is designed to remove a top foil/film (30) from the foil/film stack (36) and insert it into the cleaning device (48), and a second foil/film transfer means (34b) is configured to remove the foil/film (30) from the cleaning unit (48) and place it onto the manufacturing workpiece carrier (22) with the electronic assemblies (12) and/or workpieces (14).

13. A method (100) for connecting electronic assemblies (12) and/or for manufacturing workpieces (14), in particular for flow production and preferably using an installation according to any of the above claims 1 to 13, **characterized by the following steps**:
- prefabrication of electronic assemblies (12) and/or workpieces (14) on a manufacturing workpiece carrier (22) in the loading station (18) for processing in a manufacturing station (21), in particular comprising a preheating module, a soldering or sintering module and/or a cooling module, wherein at least one automatic application of at least one foil/film (30) onto the electronic assemblies (12) and/or the workpieces (14) as a process cover (62) takes place;
- automated displacement of the manufacturing workpiece carrier (22) from the loading station (18) to at least the manufacturing station (21);
- automated return of the manufacturing workpiece carrier (22) to the loading station (18), in particular bypassing the manufacturing station (21).

14. The method (100) according to claim 13, **wherein** during prefabrication in the loading station (18) the electronic assemblies (12) and/or workpieces (14) are transferred in automated manner from a conveying workpiece carrier (44) onto the manufacturing workpiece carrier (22), **wherein** after passage of the electronic assemblies (12) and/or the workpieces (14) through the manufacturing station (21), in particular prior to automated return of the manufacturing workpiece carrier (22) from the loading station (18) to the unloading station (20), the electronic assemblies (12) and/or the workpieces (14) are unloaded in particular in an unloading station (20) from the manufacturing workpiece carrier (22) into the conveying workpiece carrier (44).

15. The method (100) according to one of claims 13 or 14, **characterized in that** in the loading station (18)
- in a first working position (26), a mask (28) is placed in automated manner as a first process cover (62) onto the electronic assemblies (12) and/or workpieces (14) arranged on the manufacturing workpiece carrier (22);
- in a second working position (26), at least one foil/film (30), in particular a thermally resistant equalizing foil/film, is placed in automated manner as a second process cover (62) onto the mask (28);
- and in particular in a third working position (26) the foil/film (30) is fixed in place with the mask (28) and with the manufacturing workpiece carrier (22) in automated manner, preferably with a retaining ring (52).

16. The method (100) according to any of claims 13 to 15, **characterized in that** the working positions (26) are arranged in reverse order in the unloading station (20) and performed in reverse order, wherein in particular return of the manufacturing workpiece carrier (22) takes place in a plane arranged below, above or adjacent in a plane in which the manufacturing workpiece carrier (22) is arranged during loading and/or unloading, and wherein the manufacturing workpiece carrier (22) is in particular returned by a first conveying unit (24), and the conveying workpiece carrier (44) is arranged on a further conveying unit (42) which is moved in particular in automated manner, wherein the first conveying unit (24) and the further conveying unit (42) are movable mutually independently, in particular bypassing the manufacturing station (21).

17. The method (100) according to any of claims 13 to 16, **characterized in that** the conveying workpiece carrier (44) accommodates one electronic assembly (12) and/or one workpiece (14), and the manufacturing workpiece carrier (22) accommodates more than two, preferably more than five, in particular more than seven, especially twenty-four or more, electronic assemblies (12) and/or workpieces (14), such that during loading and/or unloading the manufacturing workpiece carrier (22) pauses at a position in the loading station (18) until the conveying unit (42) has fully loaded the manufacturing workpiece carrier (22) with electronic assemblies (12) and/or workpieces (14).

18. The method (100) according to any of claims 13 to 17, **characterized in that** a foil/film (30) is placed in the loading station (18) onto the manufacturing workpiece carrier (22) with the electronic assemblies (12) and/or workpieces (14) as a process cover (62), wherein the foil/film (30) is either a new foil/film (30) or a foil/film (30) already used in a previous pass of the method (100).

19. The method (100) according to claim 18, **characterized in that** the foil/film (30) is removed from a foil/film stack (36) using a foil/film transfer means (34) and placed onto the electronic assemblies (12) and/or workpieces (14), wherein the foil/film stack (36) is gradually moved upwards in the direction of a top (54) of the foil/film stack (36), such that the respectively top foil/film (30) is reachable with the foil/film transfer means (34), and wherein a check of the foil/film removal is preferably made, wherein after a certain number of foils/films (30) have been removed, the foil/film stack (36) is moved upwards to perform an upward travel of 5 mm to 15 mm, in particular 10 mm, wherein the foil/film stack (36) is moved upwards in particular after 5 to 10 foils/films (30) have been removed.

20. The method (100) according to claim 19, **characterized in that** automated cleaning of the foil/film (30) by means of a cleaning unit (48) takes place prior to the foil/film (30) being placed onto the manufacturing workpiece carrier (22) with the electronic assemblies (12) and/or workpieces (14), wherein the foil/film (30) is electrostatically discharged preferably in the cleaning unit (48) and then contaminants are removed by being blown off with compressed air and/or negative pressure.

21. The method (100) according to one of claims 19 or 20, **characterized in that** at least two foil/film stacks (36) are arranged adjacent one another, wherein a second foil/film stack (36) is moved to a position of a first foil/film stack (36) as soon as the first foil/film stack (36) no longer contains any foils/films (30), thus ensuring a continuous method.

22. The method according to any of claims 12 to 21, **characterized in that** a positionally correct alignment of the assemblies (12) and/or workpieces (14) at least in the manufacturing workpiece carrier (22) is optically detected and logged.

## Revendications

1. Système (10) pour relier des sous-ensembles électroniques (12) et/ou pour fabriquer des pièces d'oeuvre (14), notamment un système de frittage ou de brasage (10a), comprenant plusieurs modules (16) pour relier les sous-ensembles électroniques (12) et/ou pour fabriquer des pièces d'oeuvre (14), sachant qu'au moins un module (16) est conçu comme station de chargement (18) et un module (16) comme station de déchargement (20), ou un module est conçu comme station de chargement (18) et comme station de déchargement (20), sachant qu'au moins un autre module (16) est conçu comme station de fabrication (21), et un porte-pièces pour la fabrication (22) est prévu pour accueillir les sous-ensembles électroniques (12) et/ou les pièces d'oeuvre (14), lequel porte-pièces est déplaçable de manière automatisée au moyen d'une unité de transport (24), de la station de chargement (18) vers la station de déchargement (20) via la station de fabrication (21), sachant que le système (10) est conçu notamment pour une fabrication à la chaîne,
**caractérisé en ce qu'**est comprise une unité de manipulation de films (32) avec au moins deux manipulateurs de films (34) ou plus, qui est conçue pour la pose de films (30) servant de recouvrement du processus (62) dans la station de chargement (18).

2. Système (10) selon la revendication 1, **caractérisé en ce que** la station de fabrication (21) comprend au moins un autre module (16) comme module de brasage et/ou comme module de frittage, de préférence plusieurs autres modules (16), notamment un module de préchauffage, un module de plasma, un module de brasage, un module de frittage et/ou un module de refroidissement, et/ou qu'un module (16) est conçu comme station de chargement (18) et un module (16) comme station de déchargement (20), sachant que la station de chargement (18) est connectée en amont de la station de fabrication (21) et que la station de décharge (20) est connectée en aval de la station de fabrication (21), et qu'une unité de transport (24) reconduit à la station de chargement (18) les sous-ensembles électroniques (12) et/ou pièces d'oeuvre (14) provenant de la station de déchargement (20), notamment en contournant la station de fabrication (21).

3. Système (10) selon l'une des revendications précédentes, **caractérisé en ce qu'**est prévu, dans la station de chargement (18) et/ou la station de déchargement (20), au moins un robot automatisé (46) au moyen duquel les sous-ensembles électroniques (12) et/ou les pièces d'oeuvre (14) sont déposables de manière automatisée depuis un porte-pièces pour le transport (44) sur le porte-pièces pour la fabrication (22) dans la station de chargement (18), sachant qu'est prévue, pour accueillir le porte-pièces pour le transport (44), notamment une autre unité de transport (42) qui est déplaçable de la station de chargement (18) à la station de déchargement (20), indépendamment des modules (16), notamment en contournant la station de fabrication (21).

4. Système (10) selon l'une des revendications précédentes, **caractérisé en ce que** la station de chargement (18) est configurée pour poser un recouvrement du processus (62) sur les sous-ensembles électroniques (12) et/ou les pièces d'oeuvre (14), et/ou que la station de déchargement (20) est configurée pour retirer le recouvrement du processus (62) des sous-ensembles électroniques (12) et/ou des pièces d'oeuvre (14), notamment pour le mettre et/ou le retirer au moyen d'un robot automatisé (46).

5. Système (10) selon l'une des revendications précédentes, **caractérisé en ce que** la station de chargement (18) et/ou la station de déchargement (20) comprennent au moins deux positions de travail (26), notamment trois ou quatre positions de travail (26), sachant que le porte-pièces pour la fabrication (22) est déplaçable de manière automatisée d'une position de travail (26) à une position de travail (26) voisine, notamment au moyen d'une unité de déplacement (58).

6. Système (10) selon la revendication 4 ou 5, **caractérisé en ce que** la station de chargement (18) comprend trois positions de travail (26) qui sont reliées ensemble par une unité de déplacement (58), sachant que les sous-ensembles électroniques (12) et/ou les pièces d'oeuvre (14) sont déposables de manière automatisée sur une première position de travail (26) au moyen d'un robot automatisé (46), et qu'un masque (28) servant de premier recouvrement du processus (62) est déposable de manière automatisée sur les sous-ensembles électroniques (12) et/ou sur les pièces d'oeuvre (14) au moyen d'un robot automatisé (46), qu'un film (30) servant de second recouvrement du processus (62) est déposable de manière automatisée sur le masque (28) dans une deuxième position de travail (26), au moyen d'un robot automatisé, et qu'a lieu de manière automatisée dans une troisième position de travail, un scellement du porte-pièces pour la fabrication (22) avec le film (30), notamment sur un anneau de retenue (52) au moyen d'un robot automatisé (46).

7. Système (10) selon l'une des revendications 2 à 6, **caractérisé en ce que** la station de chargement (18) et la station de déchargement (20) sont conçues de manière à être l'image l'une de l'autre par symétrie miroir.

8. Système (10) selon l'une des revendications précédentes, **caractérisé en ce que** l'unité de transport (24) comprend une unité de levage (25) et une unité de convoyage souterrain (60) pour le transport du porte-pièces pour la fabrication (22), sachant que la trajectoire de déplacement de l'unité de convoyage souterrain (60) est disposée à l'intérieur du système (10), notamment en contournant la station de fabrication (21), et s'étend notamment en dessous d'un plan où a lieu un chargement et/ou déchargement du porte-pièces pour la fabrication (22), et/ou qu'est prévue une unité d'inspection optique comprenant au moins une caméra d'inspection (70a, 70b, 70c, 70d) dans la station de chargement (18) et/ou dans la station de déchargement (20), laquelle caméra peut acquérir et consigner une orientation correcte des sous-ensembles (12) et/ou des pièces d'oeuvre (14) dans le porte-pièces pour la fabrication (22).

9. Système (10) selon l'une des revendications précédentes, **caractérisé en ce que** l'unité de manipulation de films (32) comprend au moins une pile de films (36), en particulier deux qui sont conçues comme réservoir de films (38) et présente, sur une face supérieure (54), une surface de retrait (56) pour un film supérieur (30), sachant que notamment la pile de films (36) dispose d'une unité de levage de film (40) qui permet un soulèvement progressif de la pile de films (36) en direction de la face supérieure (54).

10. Unité de manipulation de films (32) et système (10) selon l'une des revendications précédentes, **caractérisés en ce que** sont compris au moins un, notamment deux manipulateurs de films (34) et au moins une, notamment deux piles de films (36), sachant que notamment une unité de nettoyage (48) est comprise pour le nettoyage d'un film supérieur et/ou d'un film inférieur (30) avant l'application sur les sous-ensembles électroniques (12) et/ou sur les pièces d'oeuvre (14), sachant que de préférence, l'unité de nettoyage (48) comprend une unité de nettoyage linéaire ou est conçue sous forme de système de nettoyage de surface, travaillant sans contact.

11. Unité de manipulation de films (32) et système selon l'une des revendications 8 à 10, **caractérisés en ce que** la pile de films (36) est conçue sous forme de réservoir de films (38) avec une unité de levage de film (40) de sorte qu'un film supérieur respectif (30) de la pile de films (36) est déplaçable d'une élévation vers le haut en direction de la face supérieure (54), et que le manipulateur de film (34) présente un système de compensation de hauteur (50).

12. Unité de manipulation de films (32) et système selon l'une des revendications 10 ou 11, **caractérisés en ce qu'**un premier manipulateur de film (34a) est conçu pour retirer un film supérieur (30) de la pile de films (36) et pour l'insérer dans l'unité de nettoyage (48), qu'un second manipulateur de film (34b) est conçu pour retirer le film (30) hors de l'unité de nettoyage (48) et le poser sur le porte-pièces pour la fabrication (22) avec les sous-ensembles électroniques (12) et/ou les pièces d'oeuvre (14).

13. Procédé (100) pour raccorder des sous-ensembles électroniques (12) et/ou pour fabriquer des pièces d'oeuvre (14), notamment pour la fabrication à la chaîne et de préférence en utilisant un système selon l'une des revendications précédentes 1 à 13, **caractérisé par les étapes suivantes** :
- Préparation des sous-ensembles électroniques (12) et/ou des pièces d'oeuvre (14) sur un porte-pièces pour la fabrication (22) dans la station de chargement (18) pour l'usinage dans une station de fabrication (21), comprenant notamment un module de préchauffage, un module de frittage ou de brasage et/ou un module de refroidissement, sachant qu'a lieu au moins une pose automatique d'au moins un film (30) comme recouvrement du processus (62) sur les sous-ensembles électroniques (12) et/ou les pièces d'oeuvre (14) ;
- Déplacement automatisé du porte-pièces pour la fabrication (22) de la station de chargement (18) vers au moins la station de fabrication (21) ;
- Retour automatisé du porte-pièces pour la fabrication (22) vers la station de chargement (18), notamment en contournant la station de fabrication (21).

14. Procédé (100) selon la revendication 13, **sachant** qu'a lieu, lors de la préparation dans la station de chargement (18), une manipulation automatisée des sous-ensembles électroniques (12) et/ou des pièces d'oeuvre (14), d'un porte-pièces pour le transport (44) sur le porte-pièces pour la fabrication (22), **sachant** qu'a lieu, notamment dans une station de déchargement (20) après traversée des sous-ensembles électroniques (12) et/ou des pièces d'oeuvre (14) à travers la station de fabrication (21), notamment avant un retour automatisé du porte-pièces pour la fabrication (22) de la station de chargement (18) à la station de déchargement (20), un déchargement des sous-ensembles électroniques (12) et/ou des pièces d'oeuvre (14) du porte-pièces pour la fabrication (22) au porte-pièces pour le transport (44).

15. Procédé (100) selon l'une des revendications 13 ou 14, **caractérisé en ce que** dans la station de chargement (18)
- dans une première position de travail (26), un masque (28) comme premier recouvrement de processus (62) est posé de manière automatisée sur les sous-ensembles électroniques (12) et/ou les pièces d'oeuvre (14) qui sont disposés sur le porte-pièces pour la fabrication (22) ;
- que dans une deuxième position de travail (26), au moins un film (30), notamment un film de compensation résistant à la température est posé de manière automatisée sur le masque (28), comme deuxième recouvrement du processus (62) ;
- que notamment dans une troisième position de travail (26), une fixation du film (30) au masque (28) et au porte-pièces pour la fabrication (22) a lieu de manière automatisée, de préférence avec un anneau de retenue (52).

16. Procédé (100) selon l'une des revendications 13 à 15, **caractérisé en ce que** dans la station de déchargement (20), les positions de travail (26) sont disposées dans l'ordre inverse et réalisées dans l'ordre inverse, sachant que notamment, le retour du porte-pièces pour la fabrication (22) a lieu dans un plan disposé en dessous, au-dessus ou au voisinage dans un plan dans lequel est disposé le porte-pièces pour la fabrication (22) lors du chargement et/ou déchargement, et sachant que notamment, le retour du porte-pièces pour la fabrication (22) a lieu au moyen d'une première unité de transport (24), et que le porte-pièces pour le transport (44) est disposé sur une autre unité de transport (42) qui se déplace, notamment de manière automatisée, sachant que la première unité de transport (24) et l'autre unité de transport (42) sont indépendantes l'une de l'autre, et sont déplaçables notamment en contournant la station de fabrication (21),

17. Procédé (100) selon l'une des revendications 13 à 16, **caractérisé en ce que** le porte-pièces pour le transport (44) accueille un sous-ensemble électronique (12) et/ou une pièce d'oeuvre (14), et que le porte-pièces pour la fabrication (22) accueille plus de deux, de préférence plus de cinq, notamment plus de sept, et en particulier vingt-quatre sous-ensembles électroniques (12) et/ou pièces d'oeuvre (14) ou plus, de sorte que lors du chargement et/ou déchargement, le porte-pièces pour la fabrication (22) demeure à une position dans la station de chargement (18) jusqu'à ce que l'unité de transport (42) ait complètement chargé le porte-pièces pour la fabrication (22) avec des sous-ensembles électroniques (12) et/ou pièces d'oeuvre (14).

18. Procédé (100) selon l'une des revendications 13 à 17, **caractérisé en ce que** dans la station de chargement (18) a lieu une pose d'un film (30) comme recouvrement du processus (62) sur le porte-pièces pour la fabrication (22) avec les sous-ensembles électroniques (12) et/ou les pièces d'oeuvre (14), sachant que le film (30) est soit un film (30) neuf, soit un film (30) déjà utilisé dans un précédent cycle du procédé (100).

19. Procédé (100) selon la revendication 18, **caractérisé en ce que** le film (30) est retiré d'une pile de films (36) avec un manipulateur de film (34) et déposé sur les sous-ensembles électroniques (12) et/ou les pièces d'oeuvre (14), sachant que la pile de films (36) est déplacée progressivement vers le haut en direction d'une face supérieure (54) de la pile de films (36), de sorte que le film supérieur respectif (30) est accessible avec le manipulateur de film (34), et sachant qu'est réalisé, de préférence, un contrôle du retrait de film, sachant que de préférence, la pile de films (36) est déplacée vers le haut, d'une élévation de 5 mm à 15 mm, notamment de 10 mm, après un certain nombre de films retirés (30), sachant que la pile de films (36) est déplacée vers le haut, notamment après 5 à 10 films retirés (30).

20. Procédé (100) selon la revendication 19, **caractérisé en ce qu'**avant la dépose du film (30) sur le porte-pièces pour la fabrication (22) avec les sous-ensembles électroniques (12) et/ou les pièces d'oeuvre (14), un nettoyage automatisé du film (30) a lieu au moyen d'une unité de nettoyage (48), sachant que le film (30) est déchargé de l'électricité statique, de préférence dans l'unité de nettoyage (48) et débarrassé ensuite des impuretés par soufflage d'air comprimé et/ou dépression.

21. Procédé (100) selon l'une des revendications 19 ou 20, **caractérisé en ce qu'**au moins deux piles de films (36) sont disposées côte à côte, sachant qu'une seconde pile de films (36) est déplacée à la position d'une première pile de films (36) dès que la première pile de films (36) ne contient plus de films (30) de sorte à assurer un procédé continu.

22. Procédé selon l'une des revendications 12 à 21, **caractérisé en ce qu'**une orientation correcte des sous-ensembles (12) et/ou des pièces d'oeuvre (14) est acquise optiquement et consignée au moins dans le porte-pièces pour la fabrication (22).
